# EUROPEAN PATENT SPECIFICATION

(11) **EP 3 895 228 B1**
(45) Date of publication and mention of the grant of the patent: **27.05.2026**
(21) Application number: 19817363.5
(22) Date of filing: 16.12.2019
(51) Int. Cl.: H10K 85/60, H10K 50/19

(54) **ORGANIC LIGHT EMITTING DEVICE AND A METHOD FOR MANUFACTURING THE SAME**
ORGANISCHE LICHTEMITTIERENDE VORRICHTUNG UND VERFAHREN ZUR HERSTELLUNG DAVON
DISPOSITIF ÉLECTROLUMINESCENT ORGANIQUE ET SON PROCÉDÉ DE FABRICATION

(30) Priority: 14.12.2018 EP 18212602
(43) Date of publication of application: 20.10.2021
(73) Proprietor: Novaled GmbH, 01099 Dresden (DE)
(72) Inventor: SENKOVSKYY, Volodymyr, 01099 Dresden (DE); DENKER, Ulrich, 01099 Dresden (DE)
(74) Representative: Bittner, Thomas L.
(86) International application number: PCT/EP2019/085275
(87) International publication number: WO 2020/120791

(56) References cited:
- EP-A1- 2 452 946
- EP-A1- 2 833 700
- EP-A1- 3 229 289
- EP-A1- 3 316 334

## Description

The present invention relates to an organic light emitting device as well as to a method for preparing the same.

### BACKGROUND ART

Organic light-emitting diodes (OLEDs), which are self-emitting devices, have a wide viewing angle, excellent contrast, quick response, high brightness, excellent driving voltage characteristics, and color reproduction. A typical OLED includes an anode, a hole transport layer (HTL), an emission layer (EML), an electron transport layer (ETL), and a cathode, which are sequentially stacked on a substrate. In this regard, the HTL, the EML, and the ETL are thin films formed from organic and / or organometallic compounds.

When a voltage is applied to the anode and the cathode, holes injected from the anode electrode move to the EML, via the HTL, and electrons injected from the cathode electrode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency.

Further known in the art are OLEDs comprising between the two electrodes two or more emission layers. Such OLEDs are called tandem OLEDs. In such tandem OLEDs charge generation layers are comprised between two emission layers, wherein n-type charge generation layers provide electrons to the light emission layer arranged closer to the anode while p-type generation layers provide holes to the light emission layer arranged near the cathode. A variety of materials for preparing such charge generation layers is known in the art, see EP 2 452 946 A1, EP 3 316 334 A1, EP 3 229 289 A1 and EP 2 833 700 A1.

However, there is still a need to improve the performance of organic light emitting diodes or materials comprised therein, in particular to improve the performance of (tandem) organic light emitting diodes comprising charge generation layers with respect to operating voltage and voltage rise over time.

It is, therefore, the object of the present invention to provide organic light emitting devices overcoming the drawbacks of the prior art, in particular to provide organic light emitting devices with lowered operating voltage and substantial reduction of voltage rise over time or materials for use in such organic light emitting devices suitable to improve such properties.

### SUMMARY OF THE INVENTION

The above object is achieved by an organic light emitting device comprising an anode, a cathode, at least two emission layers, and at least one charge generation layer, wherein the at least two emission layers are arranged between the anode and the cathode and wherein the at least one charge generation layer is arranged between two of the at least two emission layers; wherein the charge generation layer comprises a n-type sub-layer and a p-type sub-layer, wherein the n-type sub-layer comprises a) at least one first organic compound, the first organic compound comprising a conjugated system of at least 10 delocalized electrons and the first organic compound comprising at least one group P=X, wherein X is selected from O, S and Se; b) at least one second organic compound, the second organic compound comprising at least one metal complexing group, alternatively two metal complexing groups; wherein the first organic compound is different from the second organic compound; and c) a zero-valent metal dopant, wherein the zero-valent metal dopant is Li, Yb or a mixture thereof.

It was surprisingly found by the inventors that an organic light emitting device comprising two or more emission layers and a charge generation layer as defined herein is suitable to improve the performance of the organic light emitting device in particular with respect to operating voltage and voltage rise over time.

The inventive organic light emitting device according to the invention comprises at least two emission layers. However, it may be provided that the device comprises three or more emission layers. In such a case, more than one charge generation layer (each comprising a n-type sub-layer and a p-sub-layer as defined herein) may be provided between two of those layers. In this regard, it may be provided that one charge generation layer is provided between two emission layers respectively.

A metal complexing group as referred to herein is a group suitable to form a metal complex (coordination complex) with a metal ion. The formed metal complex may comprise one or more metal ions which are coordinated by one or more organic compounds comprising the metal complexing group. The metal complexing group may be a group having a lone electron pair suitable to form a coordinate covalent bond (dative bond, coordinate bond) with a metal ion.

The charge generation layer may further comprise an interlayer arranged between the n-type sub-layer and the p-type sub-layer. The n-type sub-layer and/or the p-type sub-layer may be in direct contact with the interlayer. The interlayer may comprise a metal complex or may consist of a metal complex. In this way, it is possible to further improve the properties of the organic light emitting device, in particular with respect to operating voltage and voltage rise over time.

In this regard, the metal complex comprised in or forming the interlayer may be a compound having the following structure

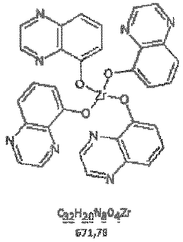

However, other suitable metal complex known in the art for this purpose and may be used as well.

The organic light emitting device according to the invention comprising an anode, a cathode, at least two emission layers, and at least one charge generation layer, wherein the at least two emission layers are arranged between the anode and the cathode and wherein the at least one charge generation layer is arranged between two of the at least two emission layers; wherein the charge generation layer comprises a n-type sub-layer and a p-type sub-layer, wherein the n-type sub-layer comprises a) at least one first organic compound, the first organic compound comprising a conjugated system of at least 10 delocalized electrons and the first organic compound comprising at least one group P=X,
wherein X is selected from O, S and Se; b) at least one second organic compound, the second organic compound comprising at least one metal complexing group, alternatively two metal complexing groups; wherein the first organic compound is different from the second organic compound;
wherein the first organic compound is different from the second organic compound; and c) a zero-valent metal dopant, wherein the zero-valent metal dopant is Li, Yb or a mixture thereof.

The first organic compound comprising at least one group P=X, wherein X is selected from O, S and Se; b) at least one second organic compound, the second organic compound comprising at least one metal complexing group according to the invention are different from each other. In this way, it is possible to further improve the properties of the organic light emitting device, in particular with respect to operating voltage and voltage rise over time.

The first organic compound and optionally the second organic compound comprises a conjugated system of at least 10 delocalized electrons.

In this way, it is possible to further improve the properties of the organic light emitting device, in particular with respect to operating voltage and voltage rise over time.

A conjugated system of delocalized electrons as referred to herein is a system of alternating π- and σ-bonds wherein, optionally, one or more two-atom structural units having the π-bond between its atoms can be replaced by an atom bearing at least one lone electron pair, typically by a divalent O or S atom. Alternatively or in an addition, the system of alternating π- and σ-bonds may embed one or more isolated boron atoms having only six valence electrons and one vacant orbital. Preferably, the conjugated system of delocalized electrons comprises at least one aromatic ring according to the Hiickel rule. The conjugated system of delocalized electrons comprises a condensed aromatic skeleton comprising at least 10 delocalized electrons, e.g. a naphthalene, anthracene, phenanthrene, pyrene, benzofurane or benzothiophene skeleton. Preferably, the conjugated system of delocalized electrons may consist of at least two directly attached aromatic rings, the simplest examples of such systems being biphenyl, bithienyl, phenylthiophene, furylthiophene and like.

The first organic compound may be represented by the following formula (I) 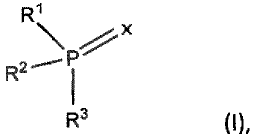 wherein X is selected from O, S and Se;
R¹, R² and R² are independently selected from the group consisting of C₁ to C₃₀ alkyl, C₃ to C₃₀ cycloalkyl, C₂ to C₃₀ heteroalkyl, C₆ to C₆₀ aryl, C₂ to C₃₀ heteroaryl, C₁ to C₃₀ alkoxy, C₃ to C₃₀ cycloalkyloxy, C₆ to C₃₀ aryloxy;
wherein each of R¹, R² and R³ may independently comprise one or more further group(s) C₆ to C₁₈ aryl, C₃ to C₂₀ heteroaryl, -PO(R')₂ (with R' being preferably phenyl and/or methyl), D, F or CN, C₁ to C₁₆ alkyl, , C₁ to C₁₆ alkoxy, nitrile,
wherein, if one or more of R¹, R² and R³ is a carbon-containing group comprising at least one carbon atom directly connected with at least one hydrogen atom, the hydrogen atoms comprised in the carbon-containing group may be partially or fully replaced by deuterium atoms and/or fluorine atoms. In this way, it is possible to further improve the properties of the organic light emitting device, in particular with respect to operating voltage and voltage rise over time.

The first organic compound may be represented by the following formula (I) 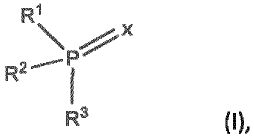
wherein X is selected from O, S and Se;
R¹, R² and R³ are independently selected from the group consisting of C₁ to C₃₀ alkyl, C₃ to C₃₀ cycloalkyl, C₂ to C₃₀ heteroalkyl, C₆ to C₆₀ aryl, C₂ to C₅₀ heteroaryl, C₁ to C₃₀ alkoxy, C₃ to C₃₀ cycloalkyloxy, C₆ to C₃₀ aryloxy;
wherein at least two of R¹, R² and R³ may be connected with each other to form together with the P atom a 5-, 6- or 7-membered ring,
wherein each of R¹, R² and R³ may independently comprise one or more further group(s) C₆ to C₁₈ aryl, C₃ to C₂₀ heteroaryl, -PO(R')₂ (with R' being preferably phenyl and/or methyl), D, F or CN, C₁ to C₁₆ alkyl, , C₁ to C₁₆ alkoxy, nitrile,
wherein, if one or more of R¹, R² and R³ is a carbon-containing group comprising at least one carbon atom directly connected with at least one hydrogen atom, the hydrogen atoms comprised in the carbon-containing group may be partially or fully replaced by deuterium atoms and/or fluorine atoms. In this way, it is possible to further improve the properties of the organic light emitting device, in particular with respect to operating voltage and voltage rise over time.

In the compound of formula (I), in case that at least two of R¹, R² and R³ are connected to each other to form, together with the P atom, a ring, this connection may include the incorporation of further groups between the two groups to be connected as long as a 5-, 6- or 7-membered ring is formed. For example, a further divalent moiety may be introduced between the R¹ and R³ to to form a ring, wherein one bond to each of these groups is formed, and the same may apply also for the couple R¹ and R² and/or for the couple R² and R³, In other words, if the groups R¹ and R² are to be connected to form together a ring, R¹ may be connected to one side of a divalent moiety and R² may be connected to the other side of the divalent moiety to form the ring. An exemplary structure of this case is the following structure

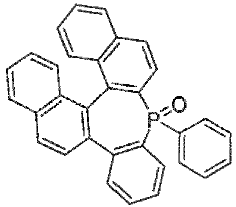

Alternatively, the two groups may be connected with each other via a single bond. In other words, in a situation where the groups R¹ and R² or R² and R³ are to be connected, a single bond is formed between these groups. A respective exemplary compound of this case is the following structure

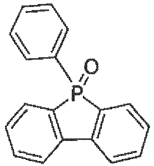

A further exemplary structure is the following structure

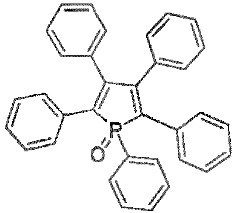

At least one of R¹, R² and R³ may comprise a conjugated system of at least 10 delocalized electrons. In this way, it is possible to further improve the properties of the organic light emitting device, in particular with respect to operating voltage and voltage rise over time.

A conjugated system of delocalized electrons as referred to herein is a system of alternating π- and σ-bonds wherein, optionally, one or more two-atom structural units having the π-bond between its atoms can be replaced by an atom bearing at least one lone electron pair, typically by a divalent O or S atom. Alternatively or in an addition, the system of alternating π- and σ-bonds may embed one or more isolated boron atoms having only six valence electrons and one vacant orbital. Preferably, the conjugated system of delocalized electrons comprises at least one aromatic ring according to the Hückel rule. The conjugated system of delocalized electrons comprises a condensed aromatic skeleton comprising at least 10 delocalized electrons, e.g. a naphthalene, anthracene, phenanthrene, pyrene, benzofurane or benzothiophene skeleton. Preferably, the conjugated system of delocalized electrons may consist of at least two directly attached aromatic rings, the simplest examples of such systems being biphenyl, bithienyl, phenylthiophene, furylthiophene and like.

According to another aspect of present invention the first organic compound may be represented by the following formula (I) 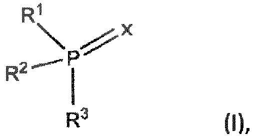 wherein X is selected from O, S and Se;
R¹, R² and R³ are independently selected from the group consisting of C₁ to C₃₀ alkyl, C₃ to C₃₀ cycloalkyl, C₂ to C₃₀ heteroalkyl, C₆ to C₆₀ aryl, C₂ to C₅₀ heteroaryl, C₁ to C₃₀ alkoxy, C₃ to C₃₀ cycloalkyloxy, C₆ to C₃₀ aryloxy;
wherein each of R¹, R² and R³ may independently comprise one or more further group(s) C₆ to C₁₈ aryl, C₃ to C₂₀ heteroaryl, -PO(R')₂ (with R' being preferably phenyl and/or methyl), D, F or CN, C₁ to C₁₆ alkyl, , C₁ to C₁₆ alkoxy, nitrile;
wherein at least two of R¹, R² or R³ are independently a C₁ to C₃₀ alkyl group.

According to another aspect of present invention the first organic compound may be represented by the following formula (I) 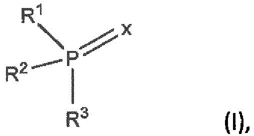 wherein X is selected from O, S and Se;
R¹, R² and R³ are independently selected from the group consisting of C₁ to C₃₀ alkyl, C₃ to C₃₀ cycloalkyl, C₂ to C₃₀ heteroalkyl, C₆ to C₆₀ aryl, C₂ to C₃₀ heteroaryl, C₁ to C₃₀ alkoxy, C₃ to C₃₀ cycloalkyloxy, C₆ to C₃₀ aryloxy;
wherein each of R¹, R² and R³ may independently comprise one or more further group(s) C₆ to C₁₈ aryl, C₃ to C₂₀ heteroaryl, -PO(R')₂ (with R' being preferably phenyl and/or methyl), D, F or CN, C₁ to C₁₆ alkyl, , C₁ to C₁₆ alkoxy, nitrile;
wherein at least two of R¹, R² or R³ are a methyl group.

At least one of R¹, R² and R³, alternatively two of R¹, R² and R³ may be phenyl or at least one, alternatively two of R¹, R² and R³ may be C₁ to C₄ alkyl, alternatively methyl.

If at least one of R¹, R² and R³ is selected from the group consisting of C₆ to C₆₀ aryl and C₂ to C₃₀ heteroaryl, wherein at least one of R¹, R² and R³ may independently comprise one or more further group(s), C₆ to C₁₈ aryl, C₃ to C₂₀ heteroaryl, -PO(R')₂ (with R' being preferably phenyl and/or methyl), D, F or CN, C₁ to C₁₆ alkyl, , C₁ to C₁₆ alkoxy, nitrile.

If at least one of R¹, R² and R³ is a carbon-containing group comprising at least one carbon atom directly connected with at least one hydrogen atom, the hydrogen atoms comprised in the carbon-containing group may be partially or fully replaced by deuterium atoms and/or fluorine atoms.

The first organic compound may be one or more selected from the following compounds

| | |
|---|---|
| 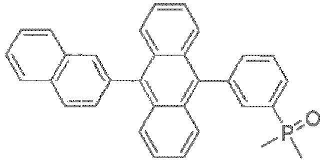 | 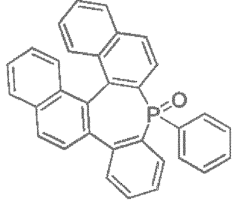 |
| 1-1 | 1-2 |
| 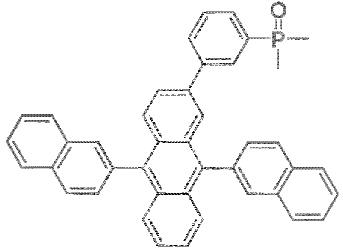 | 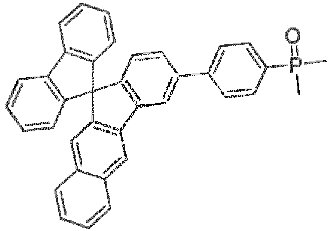 |
| 1-3 | 1-4 |
| 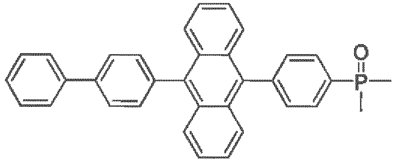 | 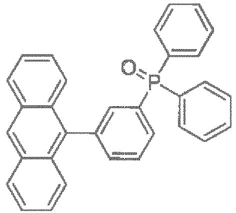 |
| 1-5 | 1-6 |
| 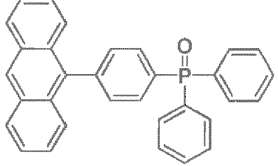 | 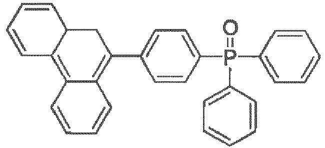 |
| 1-7 | 1-8 |
| 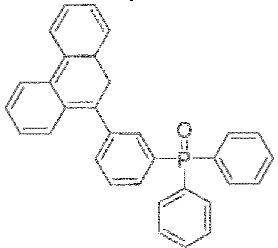 | 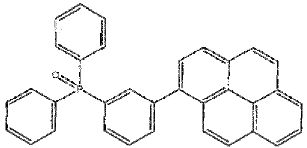 |
| 1-9 | 1-10 |
| 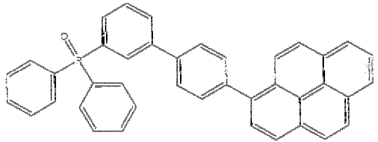 | 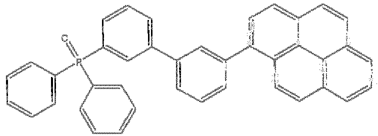 |
| 1-11 | 1-12 |
| 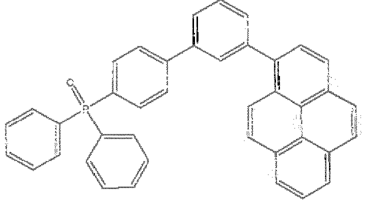 | 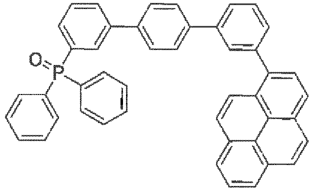 |
| 1-13 | 1-14 |
| 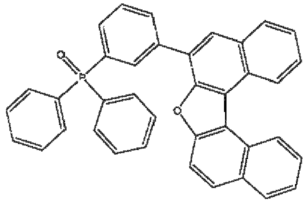 | 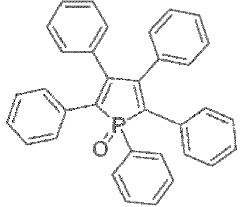 |
| 1-15 | 1-16 |
| 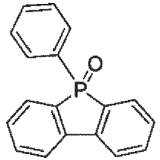 | 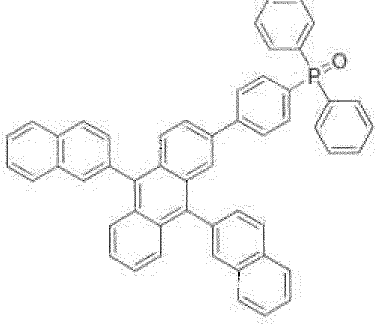 |
| 1-17 | 1-18 |
| 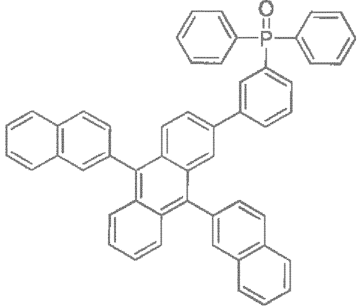 | 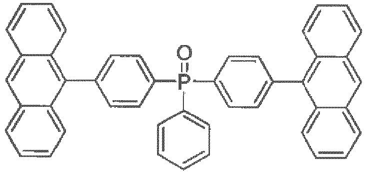 |
| 1-19 | 1-20 |
| 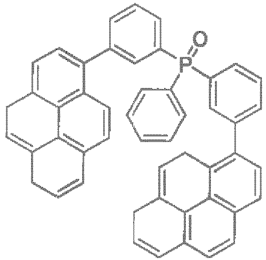 | 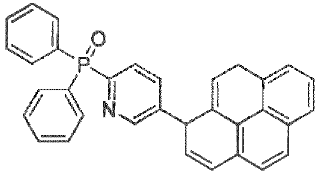 |
| 1-21 | 1-22 |
| 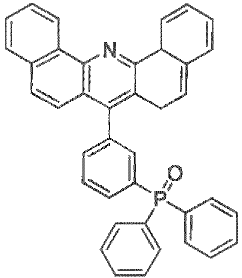 | 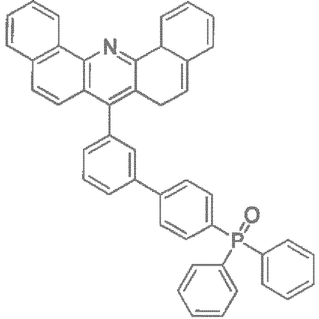 |
| 1-23 | 1-24 |
| 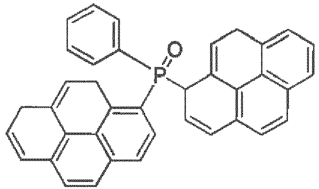 | 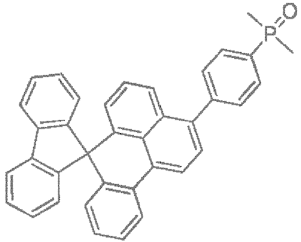 |
| 1-25 | 1-26 |
| 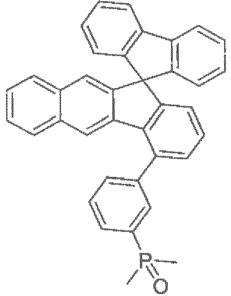 | 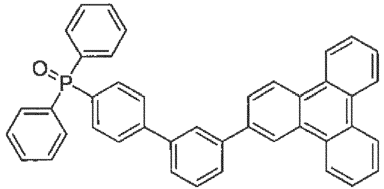 |
| 1-27 | 1-28 |
| 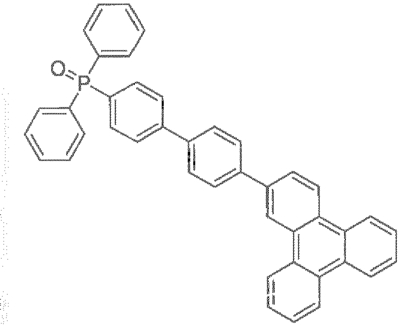 | 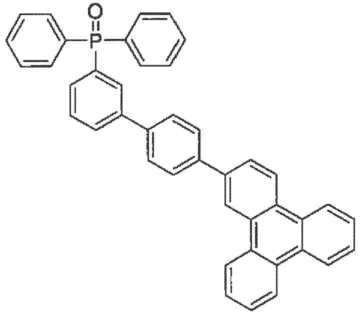 |
| 1-29 | 1-30 |
| 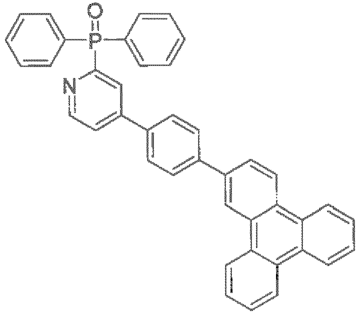 | 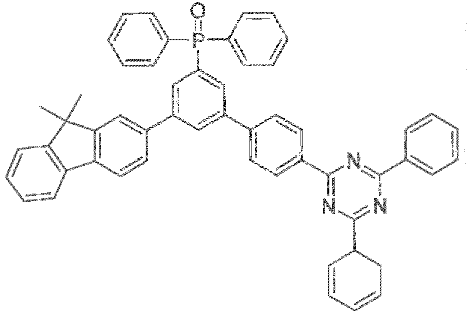 |
| 1-31 | 1-32 |
| 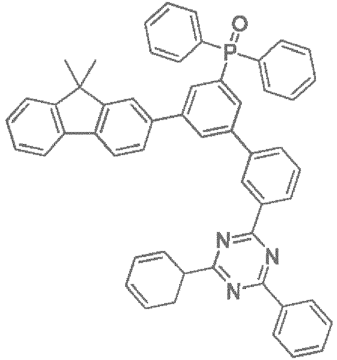 | 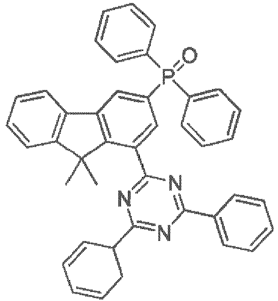 |
| 1-33 | 1-34 |
| 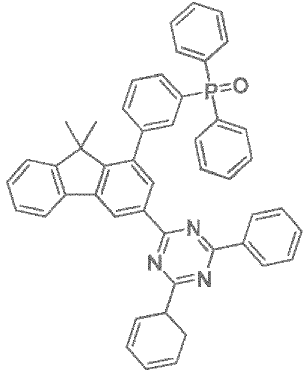 | 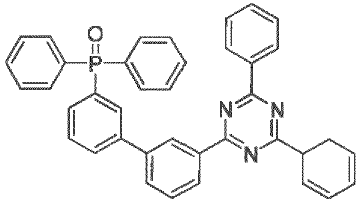 |
| 1-35 | 1-36 |
| 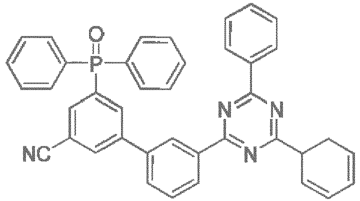 | 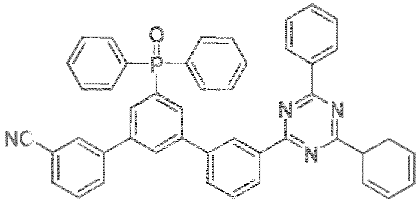 |
| 1-37 | 1-38 |
| 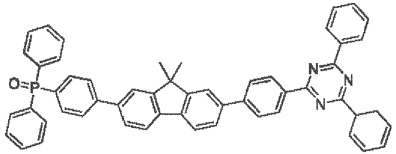 | 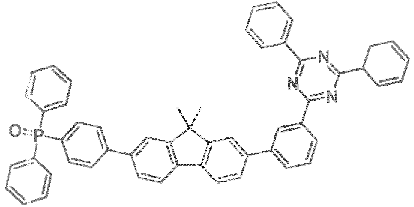 |
| 1-39 | 1-40 |
| 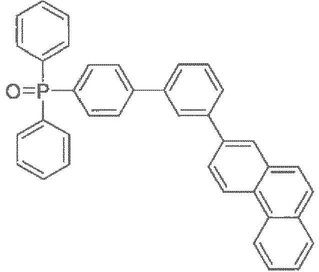 | 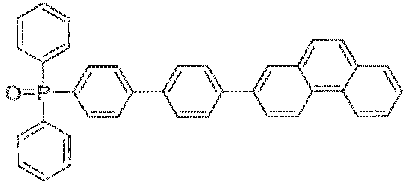 |
| 1-41 | 1-42 |

According to another aspect of the present invention the first organic compound represented by formula (I) is fully conjugated.

The metal complexing group may be a trivalent nitrogen atom. Preferably the trivalent nitrogen atom is comprised in the second organic compound included in a structure represented by the following formula 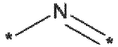 wherein * independently represent binding to a carbon atom or a nitrogen atom comprised in the second organic compound, preferably a carbon atom.

In this way, it is possible to further improve the properties of the organic light emitting device, in particular with respect to operating voltage and voltage rise over time.

The first organic compound and/or the second organic compound may independently from each other have a molecular weight from 200 to 1,000 g/mol, alternatively from 300 to 1,000 g/mol. In this way, it is possible to further improve the properties of the organic light emitting device, in particular with respect to operating voltage and voltage rise over time.

The second organic compound may comprise at least one metal complexing group comprising a C₂ to C₃₀ heteroaryl group comprising at least one nitrogen atom, preferably two C₂ to C₃₀ heteroaryl groups each comprising at least one nitrogen atom preferably benzo[h]quinoline. In this way, it is possible to further improve the properties of the organic light emitting device, in particular with respect to operating voltage and voltage rise over time.

Benzo[h]quinoline refers to the following moiety

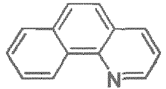

The second organic compound may comprise at least two metal complexing groups, for example two C₂ to C₃₀ heteroaryl groups comprising each at least one nitrogen atom. Preferably, the second organic compound may comprise two C₂ to C₃₀ heteroaryl groups, each comprising at least two nitrogen atoms. In one embodiment, the C₂ to C₃₀ heteroaryl group may comprise a 1,10-phenanthroline and/or a pyrido[3,2-h]quinazoline structural moiety. In this way, it is possible to further improve the properties of the organic light emitting device, in particular with respect to operating voltage and voltage rise over time.

1,10-phenanthroline refers to the following structural moiety:

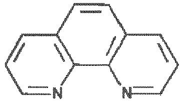

Pyrido[3,2-h]quinazoline refers to the following structural moiety:

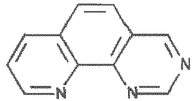

The second organic compound may be one or more of the following compounds, or may be selected form further analogous compounds disclosed in US2018166647 AA

| | |
|---|---|
| 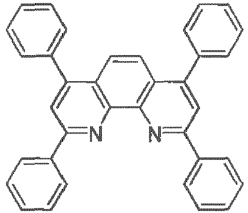 | 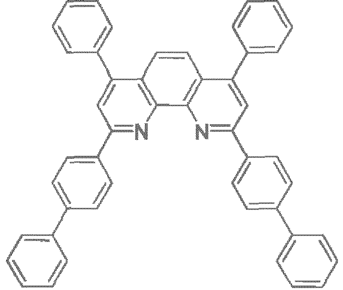 |
| 2-1 | 2-2 |
| 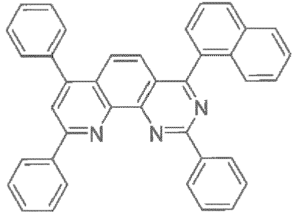 | 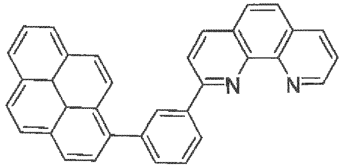 |
| 2-3 | 2-4 |
| 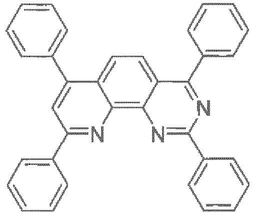 | 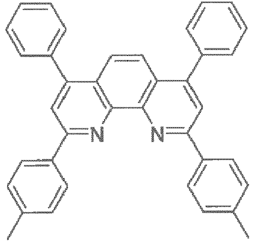 |
| 2-5 | 2-6 |
| 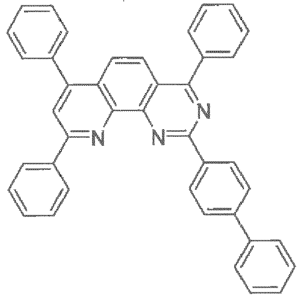 | 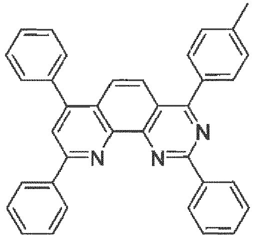 |
| 2-7 | 2-8 |
| 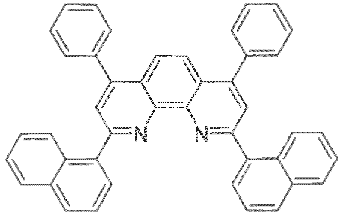 | 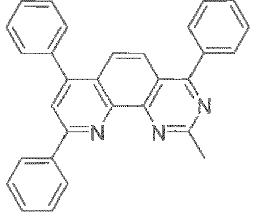 |
| 2-9 | 2-10 |
| 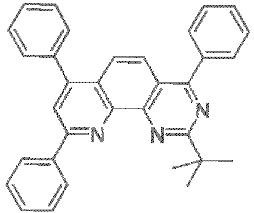 | 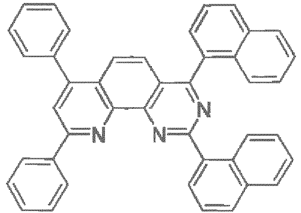 |
| 2-11 | 2-12 |
| 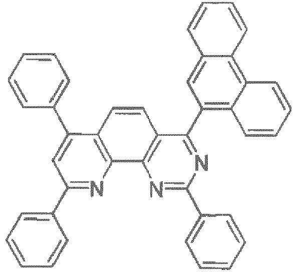 | 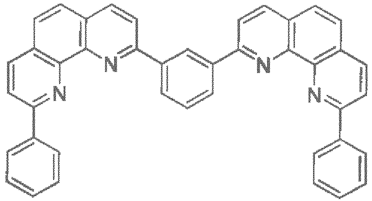 |
| 2-13 | 2-14 |
| 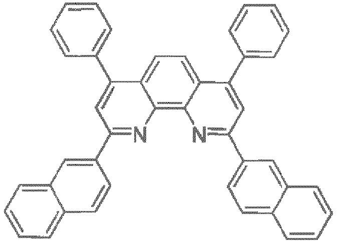 | 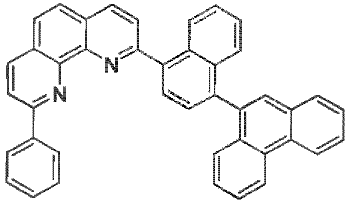 |
| 2-15 | 2-16 |
| 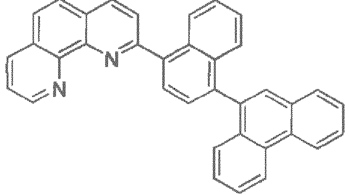 | 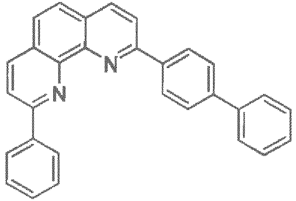 |
| 2-17 | 2-18 |
| 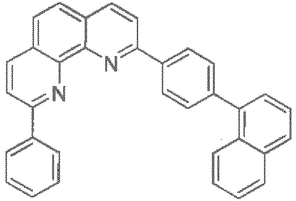 | 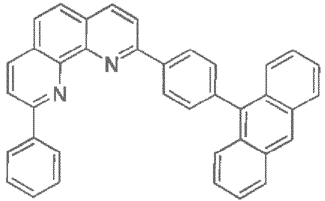 |
| 2-19 | 2-20 |
| 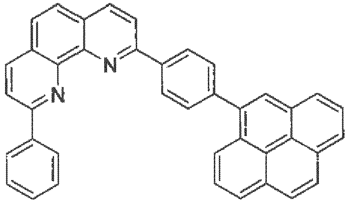 | 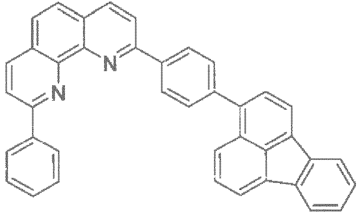 |
| 2-21 | 2-22 |
| 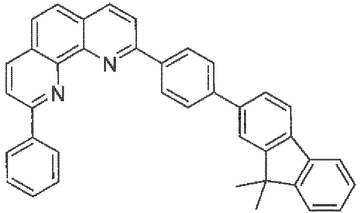 | 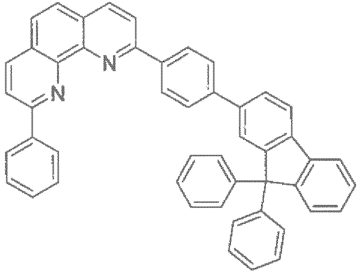 |
| 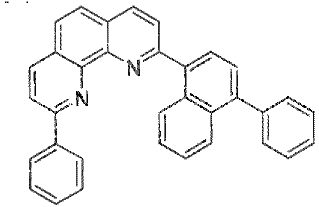 | 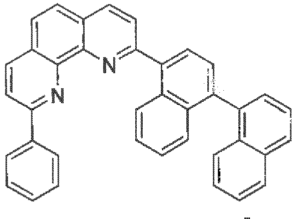 |
| 2-23 | 2-24 |
| 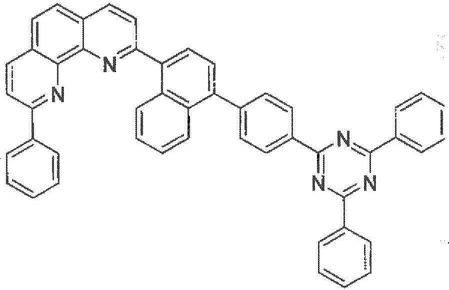 | 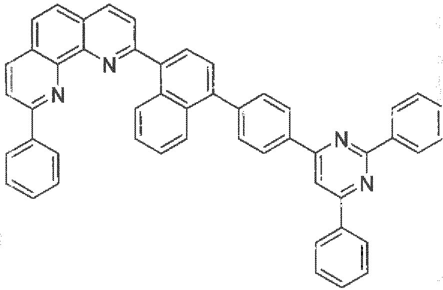 |
| 2-25 | 2-26 |
| 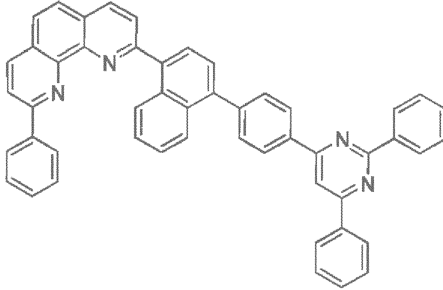 | 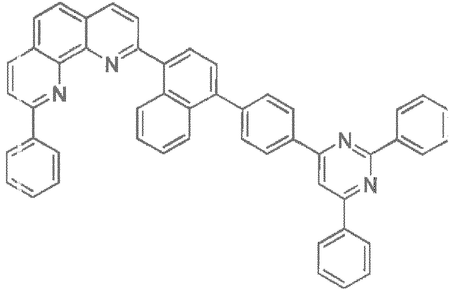 |
| 2-27 | 2-28 |
| 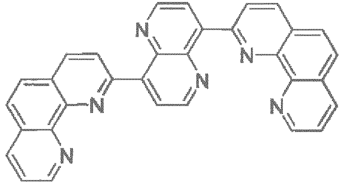 | 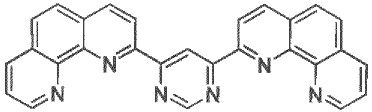 |
| 2-29 | 2-30 |
| 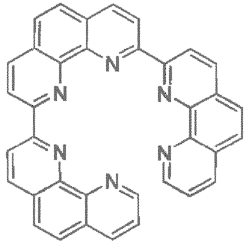 | 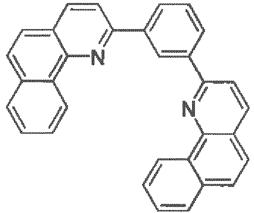 |
| 2-31 | 2-32 |
| 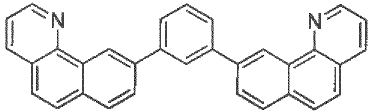 | 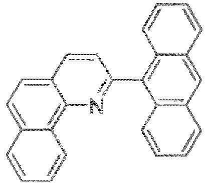 |
| 2-33 | 2-34 |
| 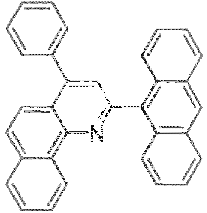 | 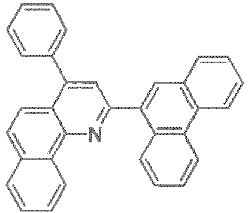 |
| 2-35 | 2-36 |

The second organic compound may comprise at least two metal complexing groups, for example two C₂ to C₃₀ heteroaryl groups comprising each at least one nitrogen atom. Preferably, the second organic compound may comprise two C₂ to C₃₀ heteroaryl groups, each comprising at least two nitrogen atoms. In one embodiment, the C₂ to C₃₀ heteroaryl group may comprise a bipyridyl or terpyridyl groups which may be substituted or unsubstituted, wherein the one or more substituents, if present, are preferably selected from such substituents shown herein with respect to the specific compounds. In this way, it is possible to further improve the properties of the organic light emitting device, in particular with respect to operating voltage and voltage rise over time.

Bipyridyl refers to the following structural moiety:

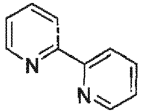

Terpyridyl refers to the following structural moiety:

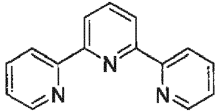

The second organic compound may be one or more of the following compounds, or may be selected form further analogous compounds:

| | |
|---|---|
| 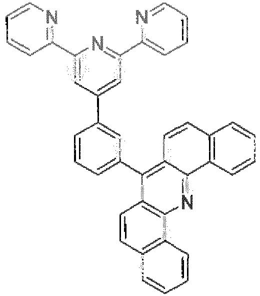 | 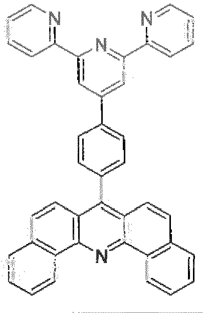 |
| 3-1 | 3-2 |
| 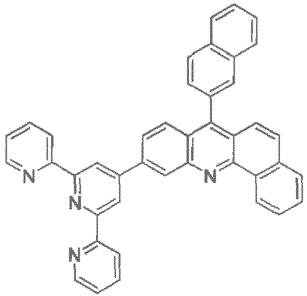 | 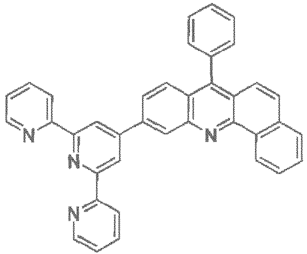 |
| 3-3 | 3-4 |
| 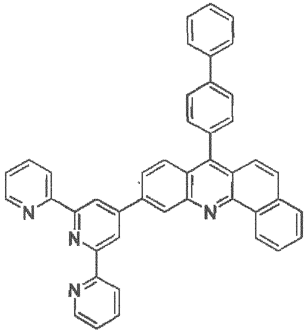 | 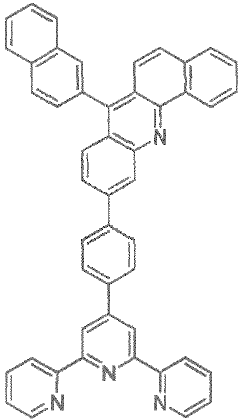 |
| 3-5 | 3-6 |
| 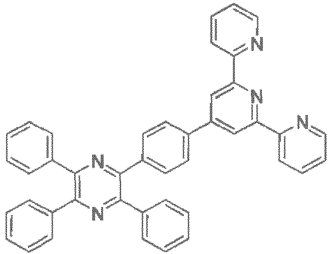 | 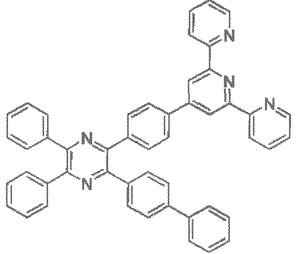 |
| 3-7 | 3-8 |
| 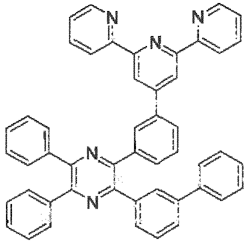 | 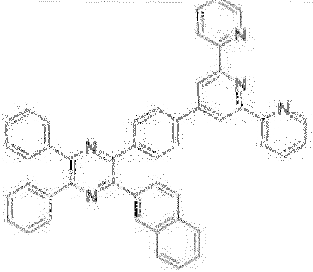 |
| 3-9 | 3-10 |
| 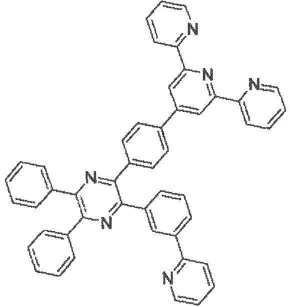 | 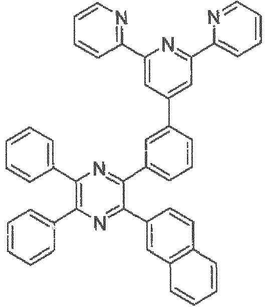 |
| 3-11 | 3-12 |
| 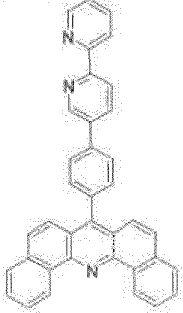 | 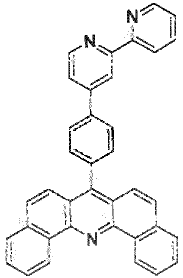 |
| 3-13 | 3-14 |
| 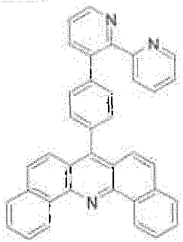 | 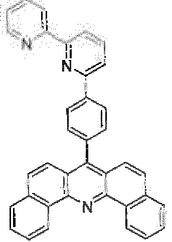 |
| 3-15 | 3-16 |
| 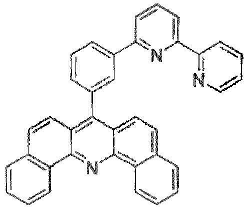 | 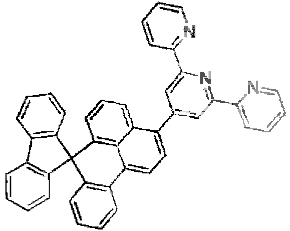 |
| 3-17 | 3-18 |
| 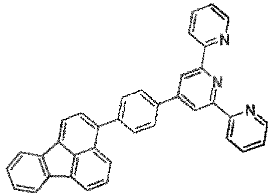 | 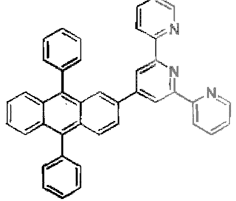 |
| 3-19 | 3-20 |
| 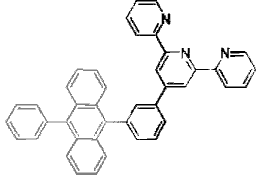 | |
| 3-21 | |

The zero-valent metal dopant is selected from Li, Yb or a mixture thereof.

In this way, it is possible to further improve the properties of the organic light emitting device, in particular with respect to operating voltage and voltage rise over time.

The object is further achieved by a method for manufacturing an organic light emitting device as defined herein, the method comprising the steps a1) evaporating the first organic compound and the second organic compound from separate evaporation sources; or a2) co-evaporating the first organic compound and the second organic compound from the same evaporation source; and b) co-depositing the first and the second organic compound on a solid support.

A solid support may also be referred to herein an organic layer deposited during the previous processing step.

Furthermore, the disclosure shows a composition consisting of a first organic compound and a second organic compound, wherein the first organic compound is a compound comprising at least one P=X group, wherein X is selected from O, S or Se; and the second organic compound comprises at least one metal complexing group, alternatively two metal complexing groups. In this regard, preferred embodiments regarding the first organic compound and the second organic compound with respect to the organic light emitting device above are also preferred embodiments for the composition.

The composition consisting of the first organic compound and the second organic compound may be in the form of a heterogeneous mixture.

Under heterogeneous mixture, it is to be understood a heterogeneous mixture consisting of preferably a physical mixture. The heterogeneity encompassed herein may be recognizable typically by optical microscope, e.g. by a polarization microscope, or by a fluorescence microscope.

The composition consisting of the first organic compound and the second organic compound may be a homogeneous composition.

Under homogeneous composition, it is to be understood a homogeneous composition consisting of a single phase. Preferably, the single phase is a solid. In addition, the object is achieved by a semiconducting material consisting of, a first organic compound and a second organic compound, alternatively consisting of the first organic compound and the second organic compound, wherein the first organic compound is a compound comprising at least one P=X group, wherein X is selected from O, S or Se; and the second organic compound comprises at least one metal complexing group, alternatively two metal complexing groups. Preferred embodiments regarding the first organic compound and the second organic compound with respect to the organic light emitting device are also preferred embodiments for the semiconducting material.

In addition, the object is achieved by a semiconducting material consisting of, a) a first organic compound b) a second organic compound and c) a zero-valent metal dopant, wherein the zero-valent metal dopant is a metal selected from Li, Yb and mixtures thereof. Alternatively consisting of a) the first organic compound, wherein the first organic compound is a compound comprising at least one P=X group, wherein X is selected from O, S or Se; b) the second organic compound, and the second organic compound comprises at least one metal complexing group, alternatively two metal complexing groups and c) a zero-valent metal dopant, wherein the zero-valent metal dopant is a metal selected from the group consisting of Li, Yb and mixtures thereof. Preferred embodiments regarding the first organic compound, the second organic compound and zero valent metal dopant with respect to the organic light emitting device are also preferred embodiments for the semiconducting material.

### Further layers

In accordance with the invention, the organic light emitting device may comprise, besides the layers already mentioned above, further layers. Exemplary embodiments of respective layers are described in the following:

### Substrate

The substrate may be any substrate that is commonly used in manufacturing organic light emitting device. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate.

### Anode electrode

Either the first electrode or the second electrode may be an anode electrode. The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO₂), aluminum zinc oxide (AlZO) and zinc oxide (ZnO), may be used to form the anode electrode. The anode electrode may also be formed using metals, typically silver (Ag), gold (Au), or metal alloys.

### Hole injection layer

The hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10⁻⁸ to 10⁻³ Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

In such a case, the HIL may be a pure layer of p-dopant or may be selected from a hole-transporting matrix compound doped with a p-dopant. Typical examples of known redox doped hole transport materials are: copper phthalocyanine (CuPc), which HOMO level is approximately -5.2 eV, doped with tetrafluoro-tetracyanoquinonedimethane (F4TCNQ), which LUMO level is about -5.2 eV; zinc phthalocyanine (ZnPc) (HOMO = - 5.2 eV) doped with F4TCNQ; α-NPD (N,N'-Bis(naphthalen-1-yl)-N,N'-bis(phenyl)-benzidine) doped with F4TCNQ. α-NPD doped with 2,2'-(perfluoronaphthalen-2,6-diylidene) dimalononitrile (PD1). α-NPD doped with 2,2',2"-(cyclopropane-1,2,3-triylidene)tris(2-(p-cyanotetrafluorophenyl)acetonitrile) (PD2). Dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

### Hole transport layer

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed by any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

### Electron blocking layer

The function of the electron blocking layer (EBL) is to prevent electrons from being transferred from the emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

The electron blocking layer may comprise a compound of formula Z below (Z).

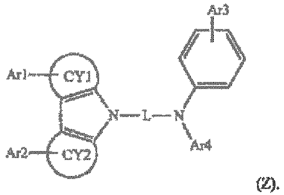

In Formula Z, CY1 and CY2 are the same as or different from each other, and each independently represent a benzene cycle or a naphthalene cycle, Ar1 to Ar3 are the same as or different from each other, and each independently selected from the group consisting of hydrogen; a substituted or unsubstituted aryl group having 6 to 30 carbon atoms; and a substituted or unsubstituted heteroaryl group having 5 to 30 carbon atoms, Ar4 is selected from the group consisting of a substituted or unsubstituted phenyl group, a substituted or unsubstituted biphenyl group, a substituted or unsubstituted terphenyl group, a substituted or unsubstituted triphenylene group, and a substituted or unsubstituted heteroaryl group having 5 to 30 carbon atoms, L is a substituted or unsubstituted arylene group having 6 to 30 carbon atoms.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Emission layer (EML)

The at least two EMLs may be formed independently on HTLs by vacuum deposition, spin coating, slot-die coat-ing, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

The respective emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA), bis(2-(2-hydroxyphenyl)benzo-thiazolate)zinc (Zn(BTZ)₂), G3 below, Compound 1 below, and Compound 2 below.

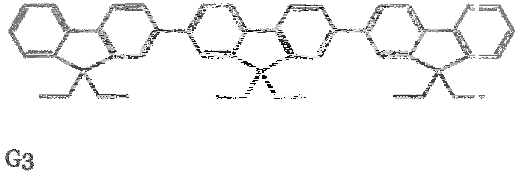

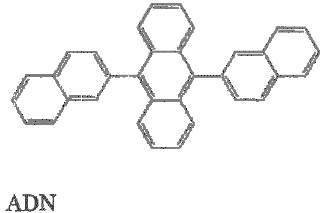

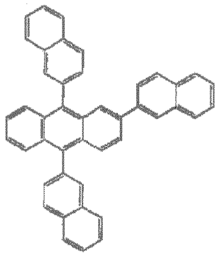

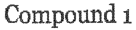

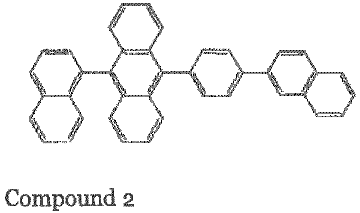

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)₃, and Btp₂lr(acac), but are not limited thereto. These compounds are phosphorescent emitters, however, fluorescent red emitter dopants could also be used.

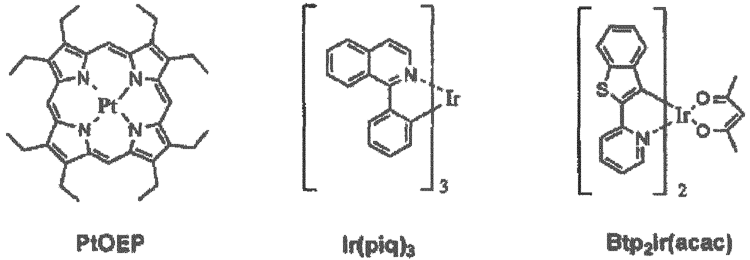

Examples of phosphorescent green emitter dopants are Ir(ppy)₃ (ppy = phenylpyridine), Ir(ppy)₂(acac), Ir(mpyp)₃ are shown below. Compound 3 is an example of a fluorescent green emitter and the structure is shown below.

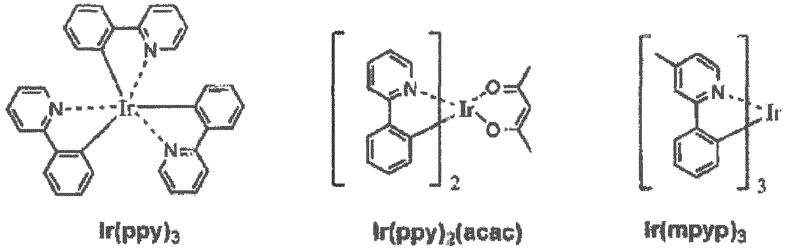

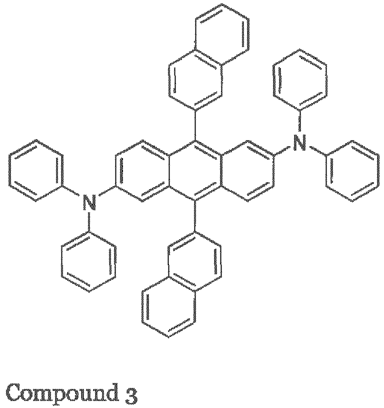

Examples of phosphorescent blue emitter dopants are F2Irpic, (F2ppy)2Ir(tmd) and Ir(dfppz)₃, ter-fluorene, the structures are shown below. 4.4'-bis(4-diphenyl amiostyryl)biphenyl (DPAVBi), 2,5,8,11-tetra-tert-butyl perylene (TBPe), and Compound 4 below are examples of fluorescent blue emitter dopants.

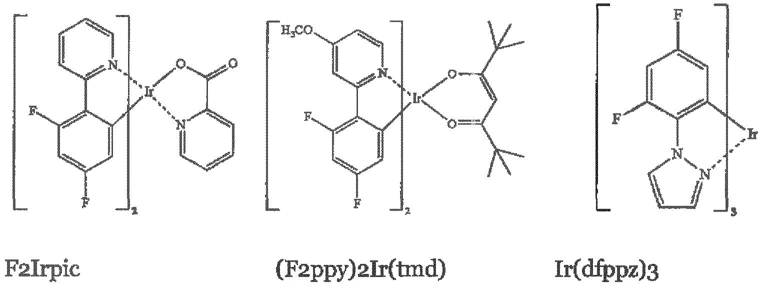

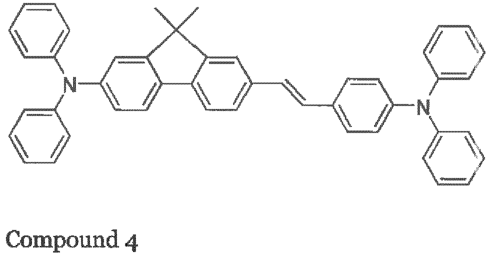

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, and phenanthroline derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The OLED according to the present invention may contain an electron transport layer (ETL).

According to various embodiments the OLED may comprise an electron transport layer or an electron transport layer stack comprising at least a first electron transport sub-layer and at least a second electron transport sub-layer.

By suitably adjusting energy levels of particular layers of the ETL, the injection and transport of the electrons may be controlled, and the holes may be efficiently blocked. Thus, the OLED may have long lifetime.

The electron transport layer of the organic light emitting device may comprise an organic electron transport matrix (ETM) material. Further, the electron transport layer may comprise one or more n-dopants. Suitable compounds for the ETM are not particularly limited. In one embodiment, the electron transport matrix compounds consist of covalently bound atoms. Preferably the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1 970 371 A1 or WO 2013/0792 17 A1.

In one embodiment, the electron transport layer maye be electrically doped with an electrical n-dopant. In another embodiment, the electron transport layer may comprise the second electron transport sub-layer which is arranged closer to the cathode than the first electron transport sub-layer and only the second electron transport sub-layer may comprise the electrical n-dopant.

The electrical n-dopant may be selected from electropositive elemental metals, and/or from metal salts and metal complexes of electropositive metals, particularly from elemental forms, salts and/or complexes of metal selected from alkali metals, alkaline earth metals, and rare earth metals.

### Electron injection layer (EIL)

The optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li₂O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode electrode

The cathode electrode is formed on the EIL if present. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy.

It is to be understood that the cathode electrode is not part of an electron injection layer or the electron transport layer.

### Charge generation layer/hole generation layer

The charge generation layer (CGL) is composed of a double layer.

The charge generation layer is a pn junction joining an n-type charge generation layer (electron generation layer) and a p-type charge generation layer (hole generation layer). The n-side of the pn junction generates electrons and injects them into the layer which is adjacent in the direction to the anode. Analogously, the p-side of the p-n junction generates holes and injects them into the layer which is adjacent in the direction to the cathode.

Charge generation layers are used in tandem devices, for example, in tandem OLEDs comprising, between two electrodes, two or more emission layers. In a tandem OLED comprising two emission layers, the n-type charge generation layer provides electrons for the first light emission layer arranged near the anode, while the p-type charge generation layer provides holes to the second light emission layer arranged between the first emission layer and the cathode.

The hole generation layer can be composed of an organic matrix material doped with p-type dopant. Suitable matrix materials for the hole generation layer may be materials conventionally used as hole injection and/or hole transport matrix materials. Also, p-type dopant used for the hole generation layer can employ conventional materials. For example, the p-type dopant can be one selected from a group consisting of tetrafluore-7,7,8,8-tetracyanoquinodimethane (F4-TCNQ), derivatives of tetracyanoquinodimethane, radialene derivatives, iodine, FeCl₃, FeF₃, and SbCl₅. Also, the host can be one selected from a group consisting of N,N'-di(naphthalen-1-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB).

In accordance with the invention, at least one n-type charge generation layer comprised in the inventive organic light emitting device is the n-type sub-layer defined herein. In case that the organic light emitting device comprises more than one n-type charge generation layers (= n-type sub-layer), it is only provided that at least one of these n-type charge generation layers is as defined therein.

In the claimed invention, n-type charge generation layer comprises a) the first organic compound, wherein the first organic compound is a compound comprising a conjugated system of at least 10 delocalized electrons and the first organic compound comprising
at least one P=X group, wherein X is selected from O, S or Se; b) the second organic compound, and the second organic compound comprises at least one metal complexing group, alternatively two metal complexing groups wherein the first organic compound is different from the second organic compound;
and c) a zero-valent metal dopant, wherein the zero-valent metal dopant is a metal selected from Li, Yb and mixtures thereof.

In a preferred embodiment, n-type charge generation layer may comprises the first organic compound and the second organic compound in a wt.-% ratio from 05:95 to 50:50, 10:90 to 50:50, 20:80 to 50:50 or 30:70 to 50:50 preferably 10:90 to 50:50, 20:80 to 50:50 or 30:70 to 50:50.

In a preferred embodiment, n-type charge generation layer may comprises the first organic compound and the second organic compound in a wt.-% ratio from 95:05 to 50:50, 90:10 to 50:50, 80:20 to 50:50 or 70:30 to 50:50 preferably 90:10 to 50:50, 80:20 to 50:50 or 70:30 to 50:50.

Alternatively, it can be provided that other n-type charge generation layers (besides the at least one) are formed differently. If the n-type charge generation layer is not a n-type sub-layer as defined therein, the n-type charge generation layer can be layer of a neat n-dopant, for example of an electropositive metal, or can consist of an organic matrix material doped with the n-dopant. In one embodiment, the n-type dopant can be alkali metal, alkali metal compound, alkaline earth metal, or alkaline earth metal compound. In another embodiment, the metal can be one selected from a group consisting of Li, Na, K, Rb, Cs, Mg, Ca, Sr, Ba, La, Ce, Sm, Eu, Tb, Dy, and Yb. More specifically, the n-type dopant can be one selected from a group consisting of Cs, K, Rb, Mg, Na, Ca, Sr, Eu and Yb. Suitable matrix materials for the electron generating layer may be the materials conventionally used as matrix materials for electron injection or electron transport layers. The matrix material can be for example one selected from a group consisting oftriazine compounds, hydroxyquinoline derivatives like tris(8-hydroxyquinoline)aluminum, benzazole derivatives, and silole derivatives.

In one embodiment, the n-type charge generation layer may include compounds of the following Chemical Formula X. 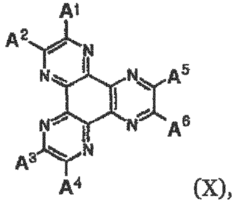 wherein each of A1 to A6 may be hydrogen, a halogen atom, nitrile (-CN), nitro (-NO2), sulfonyl (-SO2R), sulfoxide (-SOR), sulfonamide (-SO2NR), sulfonate (-SO3R), trifluoromethyl (-CF3), ester (-COOR), amide (-CONHR or - CONRR'), substituted or unsubstituted straight-chain or branched-chain C1-C12 alkoxy, substituted or unsubstituted straight-chain or branched-chain C1-C12 alkyl, substituted or unsubstituted straight-chain or branched chain C2-C12 alkenyl, a substituted or unsubstituted aromatic or non-aromatic heteroring, substituted or unsubstituted aryl, substituted or unsubstituted mono- or di-arylamine, substituted or unsubstituted aralkylamine, or the like. Herein, each of the above R and R' may be substituted or unsubstituted C1-C60 alkyl, substituted or unsubstituted aryl, or a substituted or unsubstituted 5- to 7-membered heteroring, or the like.

An example of such n-type charge generation layer may be a layer comprising CNHAT

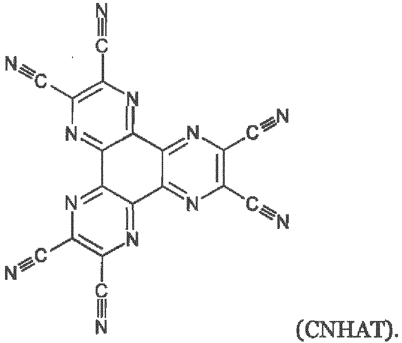

The hole generating layer is arranged on top of the n-type charge generation layer.

With regard to the method for producing the organic electronic device, the alternative embodiments outlined above may be applied mutatis mutandis. For example, the charge generation layer may be produced with an interlayer provided between the n-type sub-layer, and the p-type sub-layer.

### Organic light-emitting diode (OLED)

According to one aspect, the OLED according to the present invention can comprise a layer structure of a substrate that is adjacent arranged to an anode electrode, the anode electrode is adjacent arranged to a first hole injection layer, the first hole injection layer is adjacent arranged to a first hole transport layer, the first hole transport layer is adjacent arranged to a first electron blocking layer, the first electron blocking layer is adjacent arranged to a first emission layer, the first emission layer is adjacent arranged to a first electron transport layer, the first electron transport layer is adjacent arranged to an n-type charge generation layer (n-type sub-layer), the n-type charge generation layer is adjacent arranged to a hole generating layer (p-type sub-layer), an interlayer may be provided between the n-type sub-layer, and the p-type sub-layer, the hole generating layer is adjacent arranged to a second hole transport layer, the second hole transport layer is adjacent arranged to a second electron blocking layer, the second electron blocking layer is adjacent arranged to a second emission layer, between the second emission layer and the cathode electrode an optional electron transport layer and/or an optional injection layer are arranged.

The stack of layers may be produced by techniques known in the art as such. For example, one or more layers in the stack may be produced by vacuum thermal evaporation.

With regard to the method of producing the organic electronic device, the depositing of the plurality of layers may comprise a step of depositing the p-type sub-layer, the depositing comprising evaporation and deposition of the fullerene compound in vacuum. Preferably, all layers are deposited in vacuum.

### Details and Definitions of the invention

An organic compound as referred to herein is generally any chemical compound that contains carbon (except some compounds generally referred to as being inorganic, such as carbonates, cyanides, carbon dioxide, diamond etc.). The term organic compound used herein also encompasses compounds such as organometallic compounds, for example metallocenes etc.

The term "zero-valent" as used herein refers to a metal in the oxidation state o, i.e. particular to metals from which no electron has been removed. The zero-valent metal may be present in the form of zero-valent atoms, neat metal, alloys etc.

The term "trivalent" as used herein refers to a nitrogen atom with a single bond and a double bond and containing a lone pair of electrons.

The term "metal complexing group" as used herein refers to a group which can form a bond with a metal ion.

The term "hydrocarbyl group" as used herein shall be understood to encompass any organic group comprising carbon atoms, in particular organic groups, such as alkyl, aryl, heteroaryl, heteroalkyl, in particular such groups which are substituents usual in organic electronics.

The term "conjugated system" as used herein refer to a system of alternating π- and σ-bonds or a molecule having alternating single and multiple bonds i.e. double bond or a system having one or more two-atom structural units having the π-bond between its atoms can be replaced by an atom bearing at least one lone electron pair, typically by a divalent O or S atom.

The term "alkyl" as used herein shall encompass linear as well as branched and cyclic alkyl. For example, C₃-alkyl may be selected from n-propyl and iso-propyl. Likewise, C₄-alkyl encompasses n-butyl, sec-butyl and t-butyl. Likewise, C₆-alkyl encompasses n-hexyl and cyclo-hexyl.

The subscribed number n in Cₙ relates to the total number of carbon atoms in the respective alkyl, arylene, heteroarylene or aryl group.

The term "aryl" as used herein shall encompass phenyl (C₆-aryl), fused aromatics, such as naphthalene, anthracene, phenanthrene, tetracene etc. Further encompassed are biphenyl and oligo- or polyphenyls, such as terphenyl etc. Further encompassed shall be any further aromatic hydrocarbon substituents, such as fluorenyl etc. Arylene, respectively heteroarylene refers to groups to which two further moieties are attached.

The term "heteroaryl" as used herein refers to aryl groups in which at least one carbon atom is substituted by a heteroatom, preferably selected from N, O, S, B or Si.

The term "halogenated" refers to an organic compound in which one hydrogen atom thereof is replaced by a halogen atom. The term "perhalogenated" refers to an organic compound in which all of the hydrogen atoms thereof are replaced by halogen atoms. The meaning of the terms "fluorinated" and "perfluorinated" should be understood analogously.

The subscripted number n in Cₙ-heteroaryl merely refers to the number of carbon atoms excluding the number of heteroatoms. In this context, it is clear that a C₃ heteroarylene group is an aromatic compound comprising three carbon atoms, such as pyrazol, imidazole, oxazole, thiazole and the like.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

In the context of the present specification the term "essentially non-emissive" or "non-emissive" means that the contribution of the compound or layer to the visible emission spectrum from the device is less than 10 %, preferably less than 5 % relative to the visible emission spectrum. The visible emission spectrum is an emission spectrum with a wavelength of about ≥ 380 nm to about ≤ 780 nm.

With respect to the inventive organic light emitting device, the compounds mentioned in the experimental part may be most preferred.

The organic electroluminescent device (OLED) may be a bottom- or top-emission device.

Another aspect is directed to a device comprising at least one organic electroluminescent device (OLED). A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural formula.

The energy levels of the highest occupied molecular orbital, also named HOMO, and of the lowest unoccupied molecular orbital, also named LUMO, are measured in electron volt (eV).

The terms "OLED" and "organic light-emitting diode" are simultaneously used and have the same meaning. The term "organic electroluminescent device" as used herein may comprise both organic light emitting diodes as well as organic light emitting transistors (OLETs).

As used herein, "weight percent", "wt-%", wt%, "percent by weight", "% by weight", and variations thereof refer to a composition, component, substance or agent as the weight of that component, substance or agent of the respective electron transport layer divided by the total weight of the respective electron transport layer thereof and multiplied by 100. It is understood that the total weight percent amount of all components, substances and agents of the respective electron transport layer and electron injection layer are selected such that it does not exceed 100 wt.-%.

As used herein, "volume percent", ,vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of", "does not contain", "does not comprise" does not exclude impurities. Impurities have no technical effect with respect to the object achieved by the present invention.

### BRIEF DESCRIPTION OF THE DRAWINGS

These and/or other aspects and advantages of the present invention will become apparent and more readily appreciated from the following description of the exemplary embodiments, taken in conjunction with the accompanying drawings, of which:
Fig. 1 is a schematic representation of a layer stack of a tandem organic light emitting di-ode device;
Fig. 2 is schematic representations of a layer stack of another tandem organic light emitting diode device;
Fig. 3 is a schematic representation of a layer stack of a further tandem organic light emitting diode device;

### EMBODIMENTS OF THE INVENTIVE DEVICE

Reference will now be made in detail to the exemplary embodiments of the present invention, examples of which are illustrated in the accompanying drawings, wherein like reference numerals refer to the like elements throughout. The exemplary embodiments are described below, in order to explain the aspects of the present invention, by referring to the figures.

Herein, when a first element is referred to as being formed or disposed "on" a second element, the first element can be disposed directly on the second element or one or more other elements may be disposed there between. When a first element is referred to as being formed or disposed "directly on" a second element, no other elements are disposed there between.

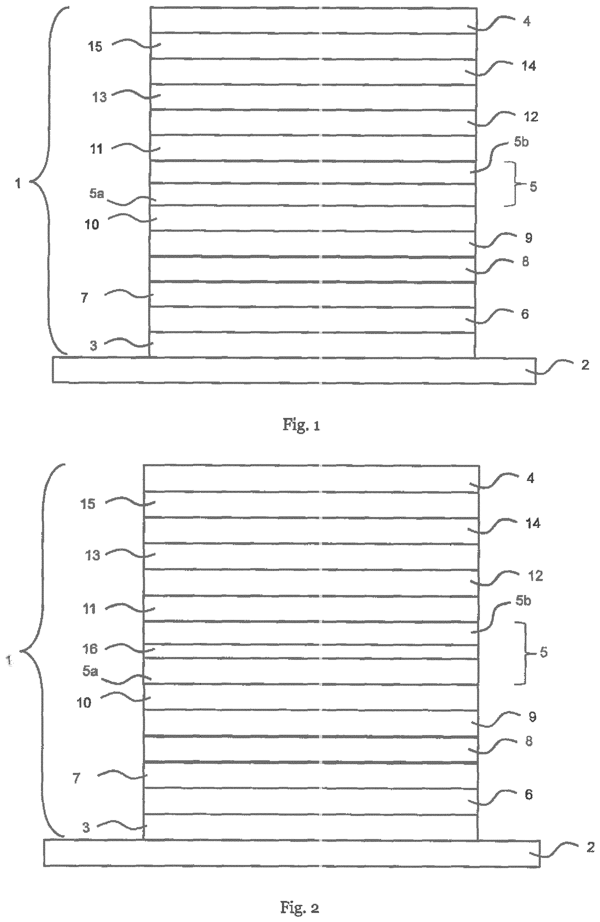

In Fig. 1, a first hole injection layer 6, a first hole transport layer 7, and a first electron blocking layer 8 are provided between the anode 3 and a first emitting layer 9. A first electron transport layer 10 is provided between the first emitting layer 9 and the charge generation layer 5 (n-type sublayer 5a and p-type sublayer 5b). A second hole injection layer 11, second hole transport layer 12, and second electron blocking layer 13 are provided between the charge generation layer 5 and a second emitting layer 14. A second electron transport layer 15 is provided between the second emitting layer 14 and the cathode 4.

Fig. 2 shows a schematic representation of another tandem OLED. The stack of layers 1 provided on the substrate 2, in addition, comprises an interlayer 16 between n-type sublayer 5a and p-type sublayer 5b.

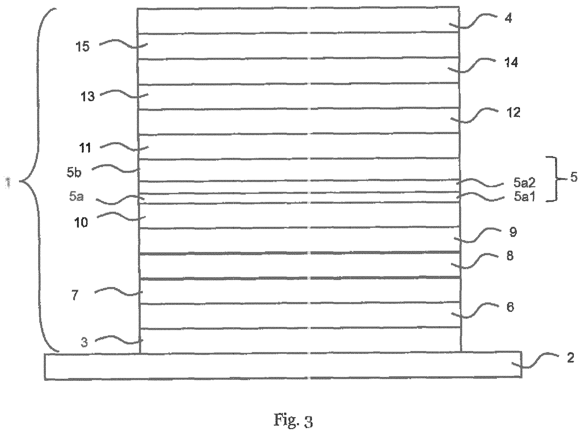

Fig. 3 shows a schematic representation of a further tandem OLED. In the stack of layers 1 provided on the substrate 2 the n-type sublayer 5a of the charge generation layer 5 comprises a first n-type sublayer 5a1 and a second n-type sublayer 5a2. In an alternative embodiment (not shown), the charge generation layer 5 of the tandem OLED in Fig. 5 may comprise the interlayer 16.

Hereinafter, one or more exemplary embodiments of the present invention will be described in detail with, reference to the following examples. However, these examples are not intended to limit the purpose and scope of the one or more exemplary embodiments of the present invention.

### Examples

### First organic matrix compound

The first organic matrix compounds were synthesized according to the procedures disclosed in WO2016162440 A1. The following compounds have been used in the device examples according to invention:

| | |
|---|---|
| 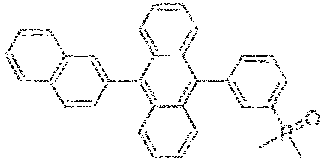 | 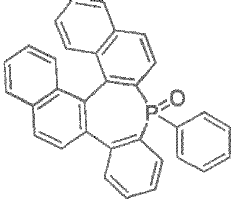 |
| 1-1 | 1-2 |
| 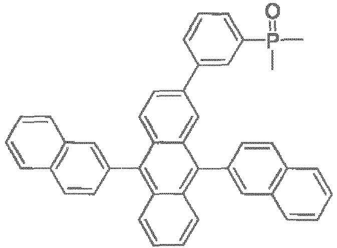 | 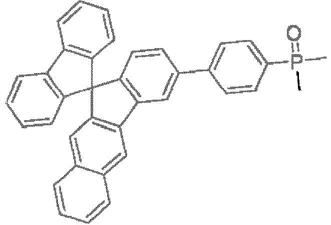 |
| 1-3 | 1-4 |
| 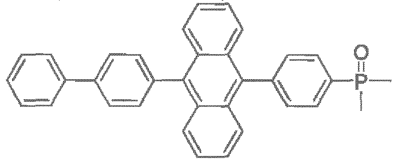 | |
| 1-5 | |

### Second organic matrix compound

The following compounds have been used in the device examples according to invention:

| | |
|---|---|
| 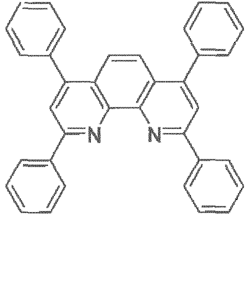 | 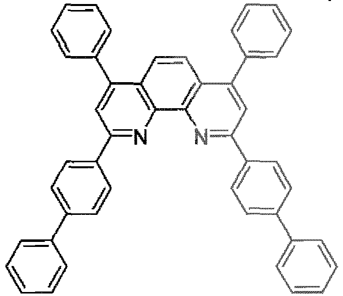 |
| 2-1 | 2-2 |
| 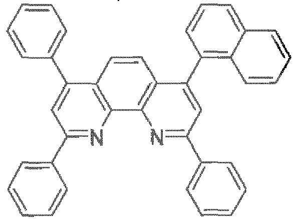 | 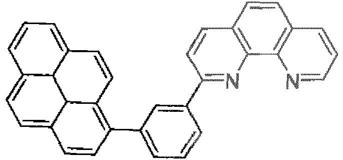 |
| 2-3 | 2-4 |
| 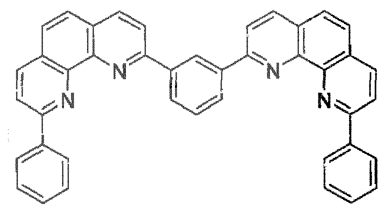 | |
| 2-14 | |

### Dopant in the n-CGL

A first zero-valent metal dopant, wherein the first zero-valent metal dopant is selected from Li, Yb amd mixtures thereof.

Ytterbium metal was used as dopant in the device examples

### Devices

### General procedure for fabrication of organic electronic devices

Organic electronic devices were prepared to demonstrate the technical benefit of an organic electronic device comprising a charge generation layer according to the present invention. A 15Ω /cm2 glass substrate with 90 nm ITO (available from Corning Co.) was cut to a size of 25 mm x 25 mm x 0.7 mm, ultrasonically cleaned with isopropyl alcohol for 5 minutes and then with pure water for 5 minutes, and cleaned again with UV ozone for 30 minutes, to prepare a first electrode. The organic layers are deposited sequentially on the ITO layer at 10-7 mbar, see Table 1 for compositions and layer thicknesses. In the Tables 1, c refers to the concentration, and d refers to the layer thickness.

Then, the cathode electrode layer is formed by evaporating aluminum at ultra-high vacuum of 10-7 mbar and deposing the aluminum layer directly on the organic semiconductor layer. A thermal single co-evaporation of one or several metals is performed with a rate of 0, 1 to 10 nm/s (0.01 to 1 Å/s) in order to generate a homogeneous cathode electrode with a thickness of 5 to 1000 nm. The thickness of the cathode electrode layer is 100 nm.

The device is protected from ambient conditions by encapsulation of the device with a glass slide. Thereby, a cavity is formed, which comprises a better material for further protection.

To assess the performance of the inventive examples compared to the prior art, the current efficiency is measured under ambient conditions (20°C). Current voltage measurements are performed using a Keithley 2400 source meter, and recorded in V.

**Table 1: Composition of organic electronic devices**

| Component | Material | Concentration (c) | Layer thickness d [Å] |
|---|---|---|---|
| Anode | ITO | | 900 |
| HIL | N-((1,1'-biphenyl]-4-yl)-9,9-dimethyl-N-(4-(9-phenyl-9H-carbazol-3-yl)phenyl)-9H-fluoren-2-amine: 4,4',4"-((1E,1'E,1"E)-cyclopropane-1,2,3-triylidenetris(cyanomethanylylidene))tris(2,3,5,6-tetrafluorobenzonitrile) | 92:8 | 400 |
| HBL | 2,4-diphenyl-6-(3'-(triphenylen-2-yl)-[1,1'-biphenyl]-3-yl)-1,3,5-triazine | | 300 |
| n-CGL | See Table 2 | 99:1 | 100 |
| p-CGL | N-([1,1'-biphenyl]-4-yl)-9,9-dimethyl-N-(4-(9-phenyl-9H-carbazol-3-yl)phenyl)-9H-fluoren-2-amine : 4,4',4"-((1E,1'E,1"E)-cyclopropane-1,2,3-triylidenetris(cyanomethanylylidene))tris(2,3,5,6-tetrafluorobenzonitrile) | 90:10 | 100 |
| a-ETL | N-([1,1'-biphenyl]-4-yl)-9,9-dimethyl-N-(4-(9-phenyl-9H-carbazol-3-yl)phenyl)-9H-fluoren-2-amine | | 300 |
| Cat | Al | | 1000 |

### Technical Effect of the invention

The beneficial effect of the invention on the performance of organic electronic devices can be seen in Table 2 and Table 3. As can be seen in Table 2, the performance of the organic electronic devices of the inventive examples 1 and 3-5 with_respect to operating voltage and voltage rise over time is improved as compare to the comparative example 1, 2 and 3.

**Table 2: Voltage of an organic electronic device comprising an n-charge generating layer**

| | n-CGL | Voltage at 30mA/cm | Voltage after 50h driving | Voltage after 50h storage | Voltage after 100h driving | Voltage after 100h storage |
|---|---|---|---|---|---|---|
| Comparative Example 1 | 1-5:Yb (99:1) | 5.09 | 0.256 | 0.088 | 0.378 | -- |
| Example 1 | 1-5:2-1:Yb (50:49:1) | 4.93 | 0.06 | 0.006 | 0.11 | 0.03 |
| Comparative Example 2 | 1-3:Yb (99:1) | 4.99 | 0.11 | 0.02 | 0.16 | 0.03 |
| Example 2 | 1-3:2-1:Yb (51:48:1) | 4.77 | 0.05 | 0 | 0.08 | -0.01 |
| Comparative Example 3 | 1-4:Yb (99:1) | 4.96 | 0.27 | 0.14 | 0.39 | 0.19 |
| Example 3 | 1-4:2-1:Yb (50:49:1) | 4.84 | 0.16 | 0.05 | 0.22 | 0.07 |
| Example 4 | 1-2:2-14:Yb (76:23:1) | 4.80 | 0.26 | 0.12 | 0.39 | 0.17 |
| Example 5 | 1-1:2-1:Yb (50:49:1) | 4.70 | 0.06 | 0.02 | 0.10 | 0.02 |

The features disclosed in the foregoing description and in the dependent claims may, both separately and in any combination thereof, be material for realizing the aspects of the disclosure made in the independent claims, in diverse forms thereof.

### General procedure for fabrication of organic electronic devices

For bottom emission devices, Examples 6-9 and 2, a 15Ω /cm² glass substrate (available from Corning Co.) with 90 nm ITO was cut to a size of 50 mm x 50 mm x 0.7 mm, ultrasonically washed with isopropyl alcohol for 5 minutes and then with pure water for 5 minutes, and washed again with UV ozone for 30 minutes, to prepare a first electrode.

Then, 97 vol.-% Biphenyl-4-yl(9,9-diphenyl-9H-fluoren-2-yl)-[4-(9-phenyl-9H-carbazol-3-yl)phenyl]-amine (CAS 1242056-42-3) with 3 vol.-% 2,2',2"-(cyclopropane-1,2,3-triylidene)tris(2-(p-cyanotetrafluorophenyl)acetonitrile) was vacuum deposited on the anode, to form a HIL having a thickness of 10 nm.

Then, Biphenyl-4-yl(9,9-diphenyl-9H-fluoren-2-yl)-[4-(9-phenyl-9H-carbazol-3-yl) phenyl]-amine was vacuum deposited on the HIL, to form a first HTL having a thickness of 128 nm.

Then N,N-bis(4-(dibenzo[b,d]furan-4-yl)phenyl)-[1,1':4',1"-terphenyl]-4-amine (CAS 1198399-61-9) was vacuum deposited on the HTL, to form an electron blocking layer (EBL) having a thickness of 5 nm.

Then 97 vol.-% H09 (Sun Fine Chemicals, South Korea) as EML host and 3 vol.-% BD200 (Sun Fine Chemicals, South Korea) as fluorescent blue dopant were deposited on the EBL, to form a first blue-emitting EML with a thickness of 20 nm.

Then the first hole blocking layer is formed with a thickness of 5 nm by 4'-(4-(4-(4,6-diphenyl-1,3,5-triazin-2-yl)phenyl)naphthalen-1-yl)-[1,1'-biphenyl]-4-carbonitrile on the emission layer.

Then, the electron transporting layer having a thickness of 25 nm is formed on the hole blocking layer by depositing 4'-(4-(4-(4,6-diphenyl-1,3,5-triazin-2-yl)phenyl)naphthalen-1-yl)-[1,1'-biphenyl]-4-carbonitrile. The electron transport layer (ETL) comprises 50 wt.-% matrix compound and 50 wt.-% of LiQ.

Then the n-CGL was formed on ETL with a thickness of 15 nm. The n-CGL comprises 1^{st} organic compound, 2^{nd} organic compound and metal dopant (Table 3). Then the p-CGL was formed on n-CGL with a thickness of 10 nm on n-CGL by depositing 90 vol.-% Biphenyl-4-yl(9,9-diphenyl-9H-fluoren-2-yl)-[4-(9-phenyl-9H-carbazol-3-yl)phenyl]-amine (CAS 1242056-42-3) with10 vol.-% 2,2',2"-(cyclopropane-1,2,3-triylidene)tris(2-(p-cyanotetrafluorophenyl)acetonitrile).

Then, Biphenyl-4-yl(9,9-diphenyl-9H-fluoren-2-yl)-[4-(9-phenyl-9H-carbazol-3-yl) phenyl]-amine was vacuum deposited on the p-CGL, to form a second HTL having a thickness of 10 nm.

Al is evaporated at a rate of 0.01 to 1 Å/s at 10⁻⁷ mbar to form a cathode with a thickness of 100 nm.

The OLED stack is protected from ambient conditions by encapsulation of the device with a glass slide. Thereby, a cavity is formed, which includes a getter material for further protection.

A tandem device stack comprising two emission layers was manufactured in the same way as above. The performance of the tandem device stack is described in Table 3.

**Table 3: Performance of a tandem organic electronic device comprising an n-CGL comprising first organic compound, second organic compound and a metal dopant**

| Example | 1^{st} Organic compound | 2^{nd} Organic compound | Metal dopant | n-CGL (vol.-%) | Thickness n-CGL (nm) | Operating voltage at 15 mA/cm² (V) | CEff/(cd/A) [1200 cd/m^{2]} | LT97 30mA/cm² (h) |
|---|---|---|---|---|---|---|---|---|
| Example 6 | 1-3 | 2-1 | Yb | 1-1:2-1:Yb (50:49:1) | 15 | 10.4 | 19.4 | 89 |
| Example 7 | 1-2 | 2-2 | Yb | 1-2:2-2:Yb (50:49:1) | 15 | 10.3 | 20.2 | 77 |
| Example 8 | 1-3 | 3-18 | Li | 1-3:3-18:Li (49:5:49.5:1) | 15 | 10.2 | 21.5 | 84 |
| Example 9 | 1-3 | 3-18 | Li | 1-3:3-18:Li (19.8:79.2:1) | 15 | 10.1 | 21.1 | -- |

The features disclosed in the foregoing description and in the dependent claims may, both separately and in any combination thereof, be material for realizing the aspects of the disclosure made in the independent claims, in diverse forms thereof.

## Claims

1. Organic light emitting device (1) comprising an anode (3), a cathode (4), at least two emission layers (9,14), and at least one charge generation layer (5), wherein the at least two emission layers (9,14) are arranged between the anode (3) and the cathode (4) and
wherein the at least one charge generation layer (5) is arranged between two of the at least two emission layers;
wherein the charge generation layer comprises a n-type sub-layer (5a) and a p-type sub-layer (5b),
wherein the n-type sub-layer (5a) comprises
a. at least one first organic compound, the first organic compound comprising a conjugated system of at least 10 delocalized electrons and the first organic compound comprising at least one group P=X, wherein X is selected from O, S and Se;
b. at least one second organic compound, the second organic compound comprising at least one metal complexing group, alternatively two metal complexing groups; wherein the first organic compound is different from the second organic compound; and
c. a zero-valent metal dopant, wherein the zero-valent metal dopant is Li, Yb or a mixture thereof.

2. Organic light emitting device according to claim 1, wherein the charge generation layer further comprises an interlayer (16) arranged between the n-type sub-layer and the p-type sub-layer.

3. Organic light emitting device according to any of the preceding claims, wherein the first organic compound and the second organic compound comprise(s) a conjugated system of at least 10 delocalized electrons.

4. Organic light emitting device according to any of the preceding, wherein the first organic compound is represented by the following formula (I) 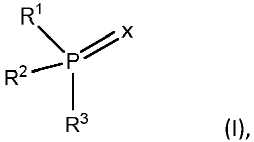 wherein X is selected from O, S and Se;
R¹, R² and R³ are independently selected from the group consisting of C₁ to C₃₀ alkyl, C₃ to C₃₀ cycloalkyl, C₂ to C₃₀ heteroalkyl, C₆ to C₆₀ aryl, C₂ to C₅₀ heteroaryl, C₁ to C₃₀ alkoxy, C₃ to C₃₀ cycloalkyloxy, C₆ to C₃₀ aryloxy;
wherein at least two of R¹, R² and R³ may be connected with each other to form together with the P atom a 5-, 6- or 7-membered ring,
wherein each of R¹, R² and R³ may independently comprise one or more further group(s) C₆ to C₁₈ aryl, C₃ to C₂₀ heteroaryl, -PO(R')₂, D, F or CN, C₁ to C₁₆ alkyl, C₁ to C₁₆ alkoxy, nitrile, wherein R' is phenyl and/or methyl,
wherein, if one or more of R¹, R² and R³ is a carbon-containing group comprising at least one carbon atom directly connected with at least one hydrogen atom, the hydrogen atoms comprised in the carbon-containing group may be partially or fully replaced by deuterium atoms and/or fluorine atoms.

5. Organic light emitting device according to any of the preceding claims, wherein at least one of R¹, R² and R³ is phenyl or at least one of R¹, R² and R³ is C₁ to C₄ alkyl.

6. Organic light emitting device according to claim 5, wherein R³ is selected from the group consisting of substituted or unsubstituted C₆ to C₆₀ aryl and C₂ to C₅₀ heteroaryl, wherein R³ may independently comprise one or more further group(s), C₆ to C₁₈ aryl, C₃ to C₂₀ heteroaryl, -PO(R')₂, D, F or CN, C₁ to C₁₆ alkyl, C₁ to C₁₆ alkoxy, nitrile, wherein R' is phenyl and/or methyl,
wherein if R³ is a carbon-containing group comprising at least one carbon atom directly connected with at least one hydrogen atom, the hydrogen atoms comprised in the carbon-containing group may be partially or fully replaced by deuterium atoms and/or fluorine atoms.

7. Organic light emitting device according to any of the preceding claims, wherein the first organic compound is one or more selected from the following compounds
| | |
|---|---|
| 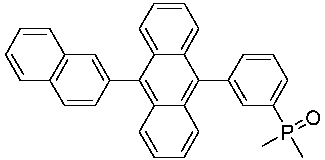 | 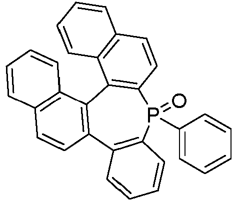 |
| 1-1 | 1-2 |
| 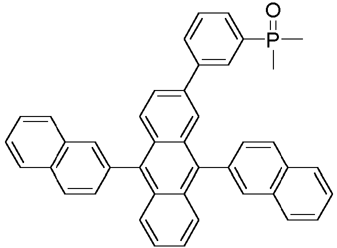 | 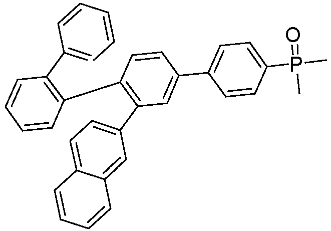 |
| 1-3 | 1-4 |
| 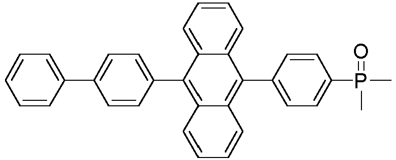 | 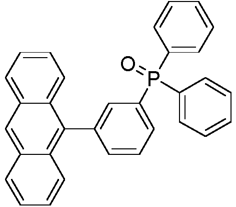 |
| 1-5 | 1-6 |
| 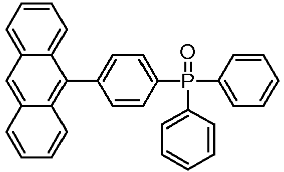 | 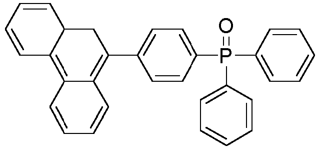 |
| 1-7 | 1-8 |
| 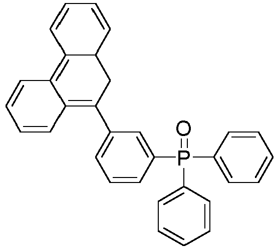 | 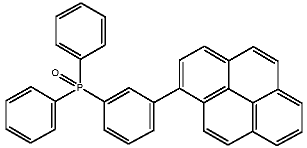 |
| 1-9 | 1-10 |
| 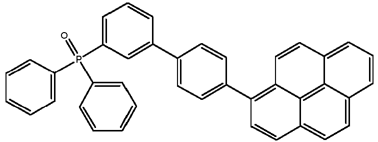 | 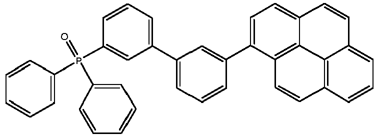 |
| 1-11 | 1-12 |
| 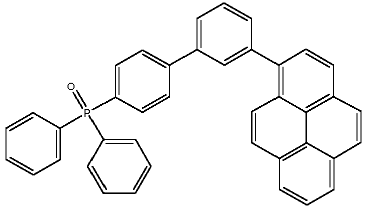 | 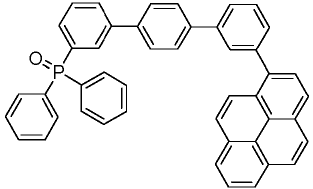 |
| 1-13 | 1-14 |
| 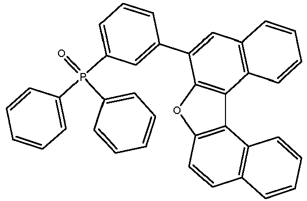 | 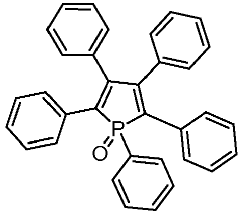 |
| 1-15 | 1-16 |
| 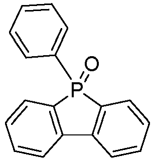 | 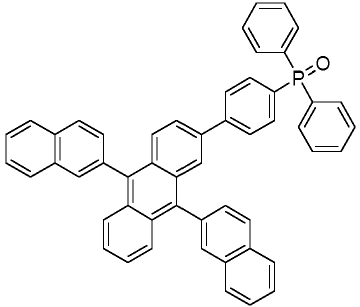 |
| 1-17 | 1-18 |
| 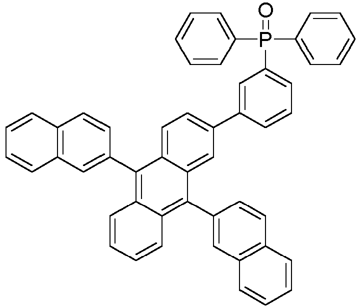 | 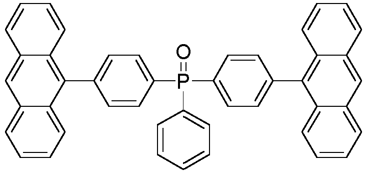 |
| 1-19 | 1-20 |
| 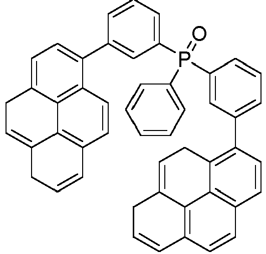 | 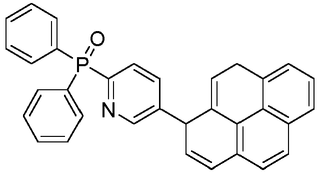 |
| 1-21 | 1-22 |
| 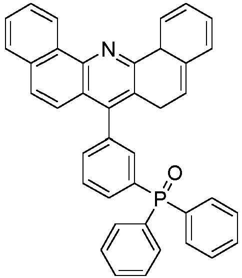 | 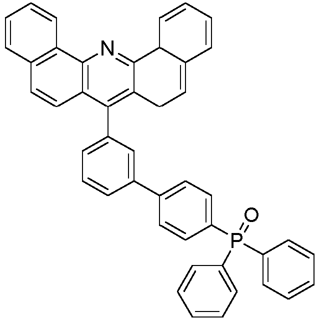 |
| 1-23 | 1-24 |
| 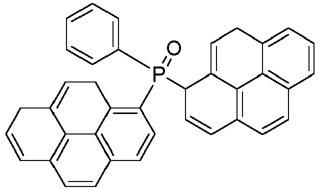 | 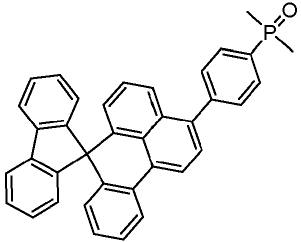 |
| 1-25 | 1-26 |
| 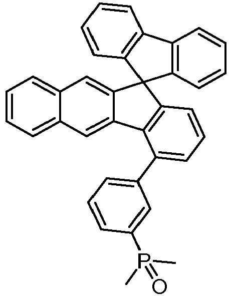 | 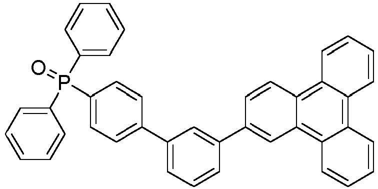 |
| 1-27 | 1-28 |
| 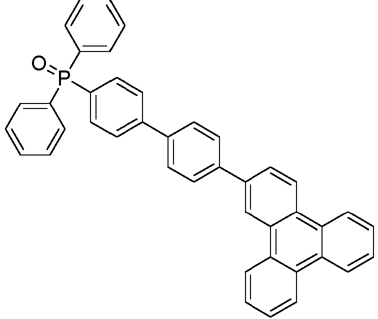 | 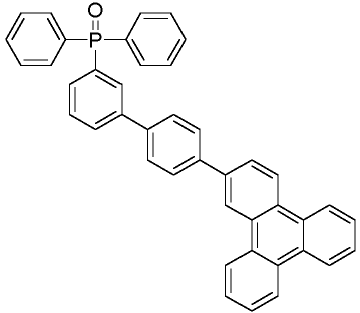 |
| 1-29 | 1-30 |
| 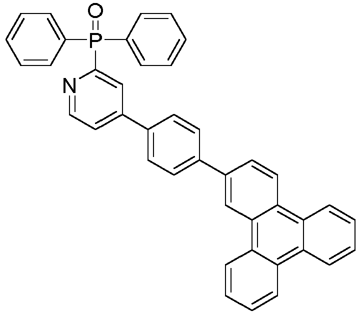 | 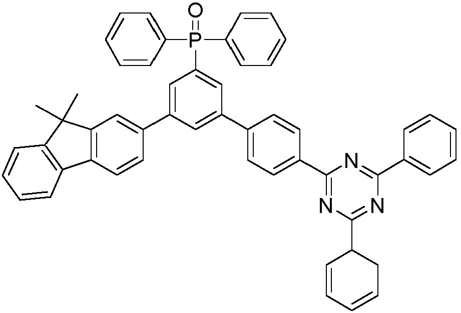 |
| 1-31 | 1-32 |
| 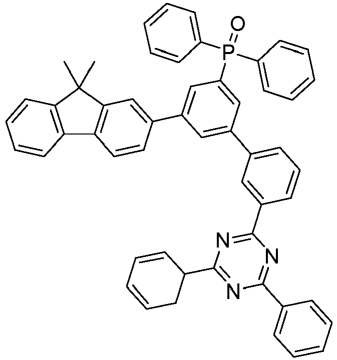 | 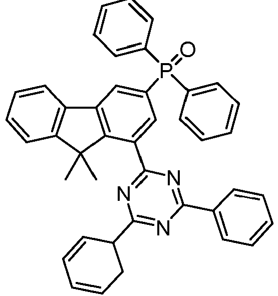 |
| 1-33 | 1-34 |
| 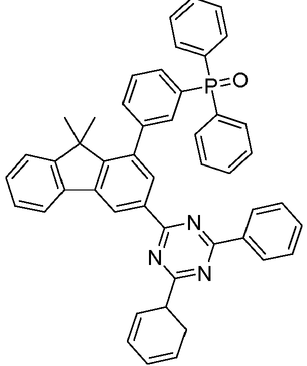 | 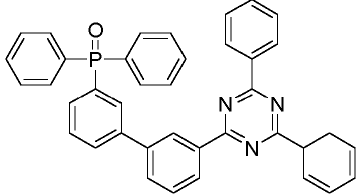 |
| 1-35 | 1-36 |
| 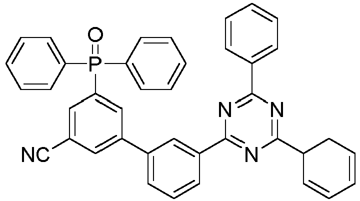 | 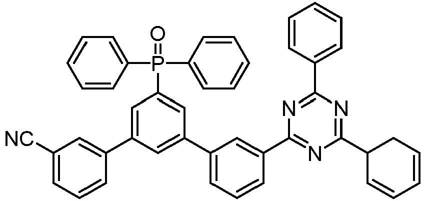 |
| 1-37 | 1-38 |
| 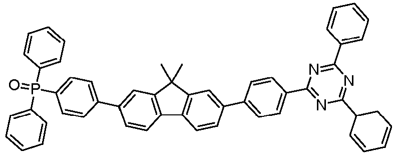 | 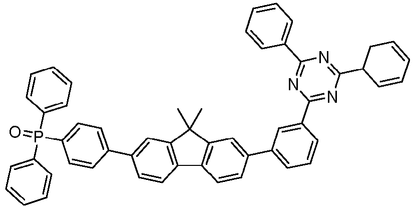 |
| 1-39 | 1-40 |
| 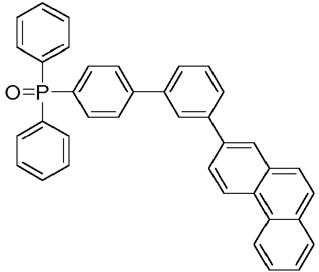 | 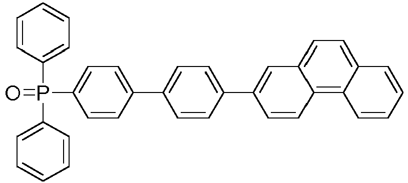 |
| 1-41 | 1-42 |

8. Organic light emitting device according to any of the preceding claims, wherein the metal complexing group is a trivalent nitrogen atom.

9. Organic light emitting device according to any of the preceding claims, wherein the second organic compound comprises at least one metal complexing group comprising a C₂ to C₃₀ heteroaryl group comprising at least one nitrogen atom.

10. Organic light emitting device according to any of the preceding claims, wherein the second organic compound comprises at least one metal complexing group comprising at least two nitrogen atoms.

11. Organic light emitting device according to any of the preceding claims, wherein the second organic compound is one or more of the following compounds
| | |
|---|---|
| 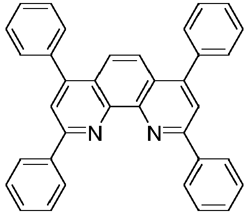 | 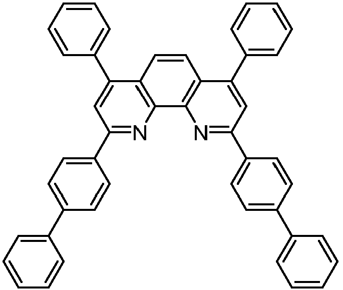 |
| 2-1 | 2-2 |
| 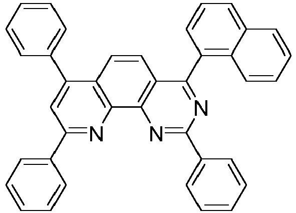 | 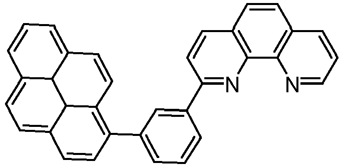 |
| 2-3 | 2-4 |
| 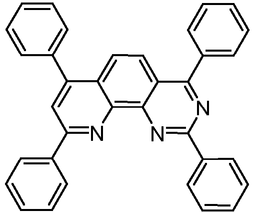 | 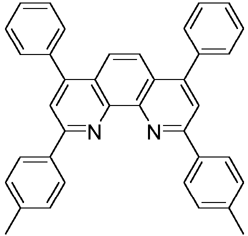 |
| 2-5 | 2-6 |
| 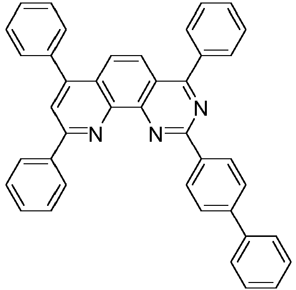 | 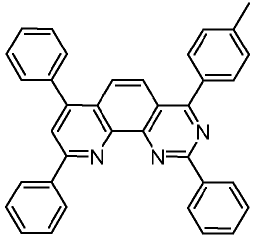 |
| 2-7 | 2-8 |
| 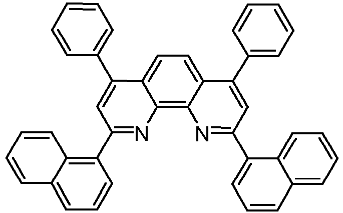 | 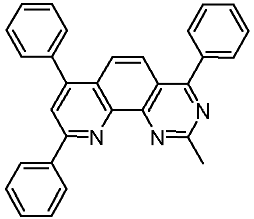 |
| 2-9 | 2-10 |
| 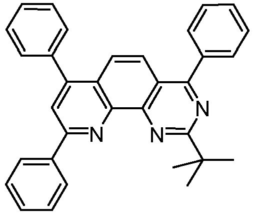 | 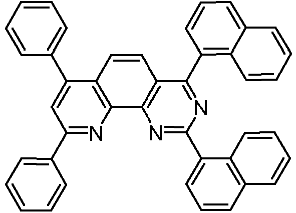 |
| 2-11 | 2-12 |
| 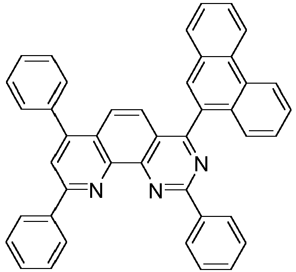 | 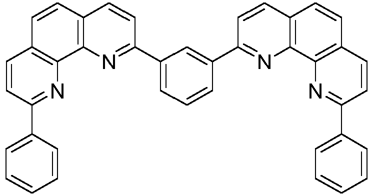 |
| 2-13 | 2-14 |
| 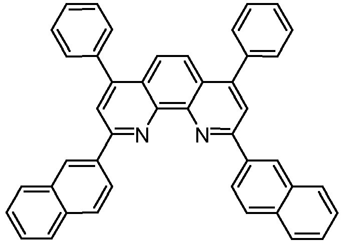 | 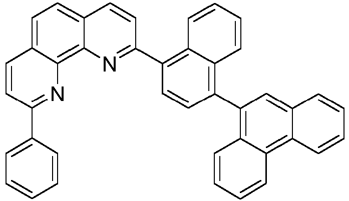 |
| 2-15 | 2-16 |
| 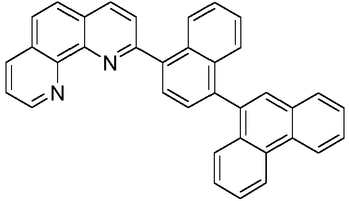 | 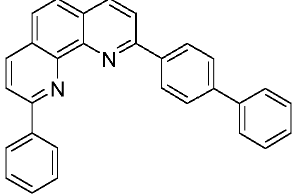 |
| 2-17 | 2-18 |
| 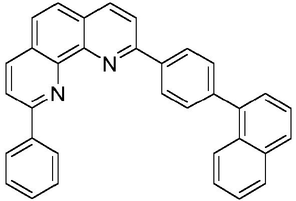 | 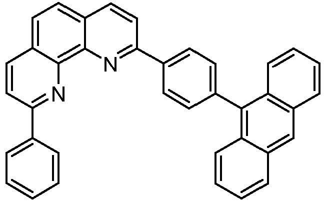 |
| 2-19 | 2-20 |
| 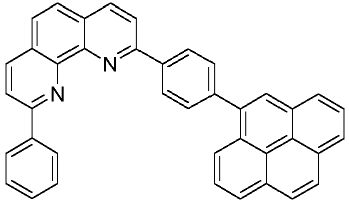 | 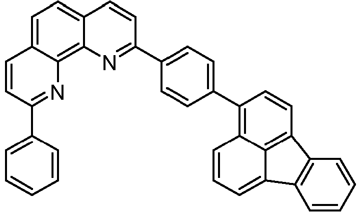 |
| 2-21 | 2-22 |
| 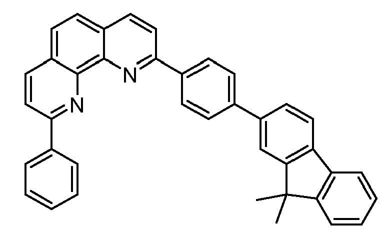 | 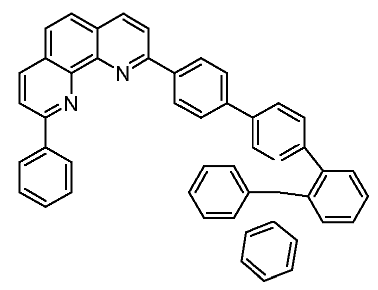 |
| 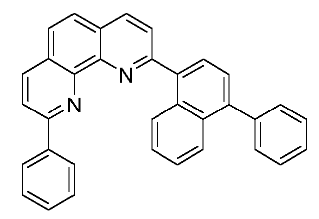 | 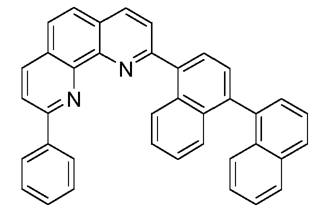 |
| 2-23 | 2-24 |
| 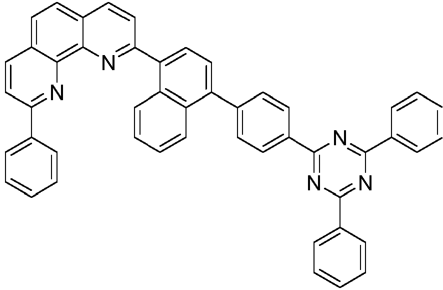 | 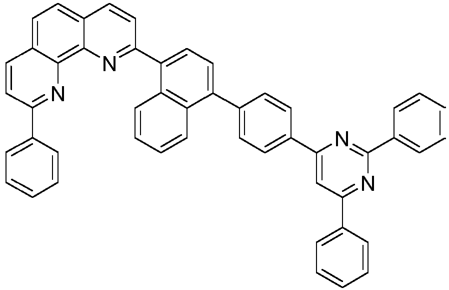 |
| 2-25 | 2-26 |
| 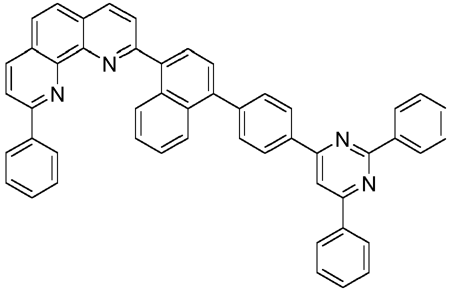 | 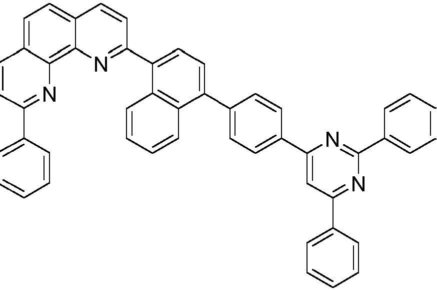 |
| 2-27 | 2-28 |
| 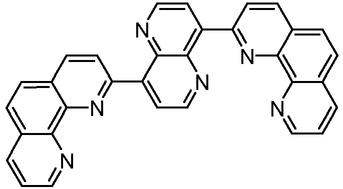 | 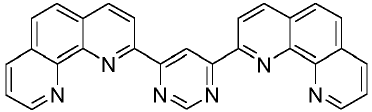 |
| 2-29 | 2-30 |
| 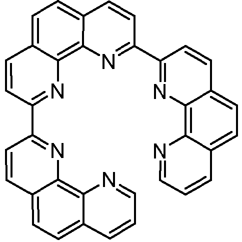 | 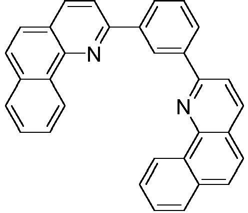 |
| 2-31 | 2-32 |
| 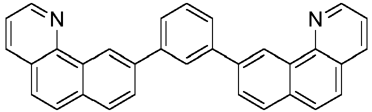 | 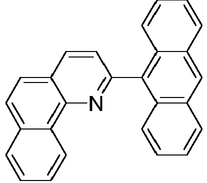 |
| 2-33 | 2-34 |
| 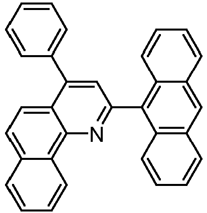 | 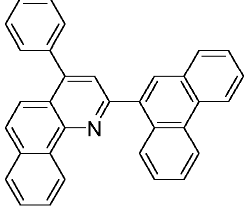 |
| 2-35 | 2-36 |

12. Method for manufacturing an organic light emitting device according to any of the preceding claims, the method comprising the steps
a1) evaporating the first organic compound and the second organic compound from separate evaporation sources; or
a2) co-evaporating the first organic compound and the second organic compound from the same evaporation source; and
b) co-depositing the first and the second organic compound.

## Patentansprüche

1. Organische lichtemittierende Vorrichtung, umfassend eine Anode, eine Kathode, mindestens zwei Emissionsschichten und mindestens eine Ladungserzeugungsschicht, wobei die mindestens zwei Emissionsschichten zwischen der Anode und der Kathode angeordnet sind und wobei die mindestens eine Ladungserzeugungsschicht zwischen zwei der mindestens zwei Emissionsschichten angeordnet ist;
wobei die Ladungserzeugungsschicht eine Unterschicht vom n-Typ und eine Unterschicht vom p-Typ umfasst,
wobei die Unterschicht vom n-Typ umfasst
a. mindestens eine erste organische Verbindung, wobei die erste organische Verbindung ein konjugiertes System aus mindestens 10 delokalisierten Elektronen umfasst und die erste organische Verbindung mindestens eine Gruppe P=X umfasst, wobei X aus O, S und Se ausgewählt ist;
b. mindestens eine zweite organische Verbindung, wobei die zweite organische Verbindung mindestens eine metallkomplexierende Gruppe, alternativ zwei metallkomplexierende Gruppen, umfasst; wobei die erste organische Verbindung von der zweiten organischen Verbindung verschieden ist; und
c. einen nullwertigen Metalldotierstoff, wobei der nullwertige Metalldotierstoff Li, Yb oder eine Mischung davon ist.

2. Organische lichtemittierende Vorrichtung nach Anspruch 1, wobei die Ladungserzeugungsschicht ferner eine Zwischenschicht umfasst, die zwischen der Unterschicht vom n-Typ und der Unterschicht vom p-Typ angeordnet ist.

3. Organische lichtemittierende Vorrichtung nach einem der vorhergehenden Ansprüche, wobei die erste organische Verbindung und/oder die zweite organische Verbindung ein konjugiertes System aus mindestens 10 delokalisierten Elektronen umfasst.

4. Organische lichtemittierende Vorrichtung nach einem der vorhergehenden Ansprüche, wobei die erste organische Verbindung durch die folgende Formel (I) dargestellt wird: 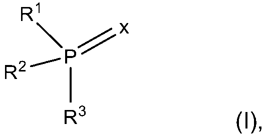
wobei X aus O, S und Se ausgewählt ist;
R¹, R² und R³ unabhängig aus der Gruppe bestehend aus C₁ - bis C₃₀ -Alkyl, C₃ - bis C₃₀ -Cycloalkyl, C₂ - bis C₃₀ -Heteroalkyl, C₆ - bis C₆₀ -Aryl, C₂ - bis C₅₀ -Heteroaryl, C₁ - bis C₃₀ -Alkoxy, C₃ - bis C₃₀ -Cycloalkyloxy, C₆ - bis C₃₀ -Aryloxy ausgewählt sind; wobei mindestens zwei von R¹, R² und R³ miteinander verbunden sein können, um zusammen mit dem P-Atom einen 5-, 6- oder 7-gliedrigen Ring zu bilden,
wobei jedes von R¹, R² und R³ unabhängig eine oder mehrere weitere Gruppe(n) C₆ - bis C₁₈ -Aryl, C₃ - bis C₂₀ -Heteroaryl, -PO(R')₂ (wobei R' Phenyl und/oder Methyl ist), D, F oder CN, C₁ - bis C₁₆ -Alkyl, C₁ - bis C₁₆ -Alkoxy, Nitril umfassen kann, wobei, wenn eines oder mehrere von R¹, R² und R³ eine kohlenstoffhaltige Gruppe ist, die mindestens ein Kohlenstoffatom umfasst, das direkt mit mindestens einem Wasserstoffatom verbunden ist, die Wasserstoffatome, die in der kohlenstoffhaltigen Gruppe enthalten sind, teilweise oder vollständig durch Deuteriumatome und/oder Fluoratome ersetzt sein können.

5. Organische lichtemittierende Vorrichtung nach einem der vorhergehenden Ansprüche, wobei mindestens eines von R¹, R² und R³ Phenyl ist oder mindestens eines von R¹, R² und R³ C₁ - bis C₄ -Alkyl ist.

6. Organische lichtemittierende Vorrichtung nach Anspruch 5, wobei R³ aus der Gruppe bestehend aus substituiertem oder unsubstituiertem C₆ - bis C₆₀ -Aryl und C₂ - bis C₅₀ - Heteroaryl ausgewählt ist, wobei R³ unabhängig eine oder mehrere weitere Gruppe(n), C₆ - bis C₁₈ -Aryl, C₃ - bis C₂₀ -Heteroaryl, -PO(R')₂ (wobei R' vorzugsweise Phenyl und/oder Methyl ist), D, F oder CN, C₁ - bis C₁₆ -Alkyl, C₁ - bis C₁₆ -Alkoxy, Nitril umfassen kann, wobei, wenn R³ eine kohlenstoffhaltige Gruppe ist, die mindestens ein Kohlenstoffatom umfasst, das direkt mit mindestens einem Wasserstoffatom verbunden ist, die Wasserstoffatome, die in der kohlenstoffhaltigen Gruppe enthalten sind, teilweise oder vollständig durch Deuteriumatome und/oder Fluoratome ersetzt sein können.

7. Organische lichtemittierende Vorrichtung nach einem der vorhergehenden Ansprüche, wobei die erste organische Verbindung eine oder mehrere ist, die aus den folgenden Verbindungen ausgewählt sind:
| | |
|---|---|
| 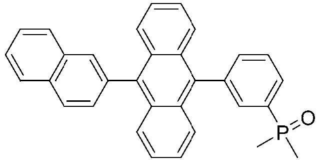 | 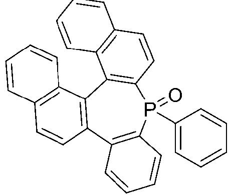 |
| 1-1 | 1-2 |
| 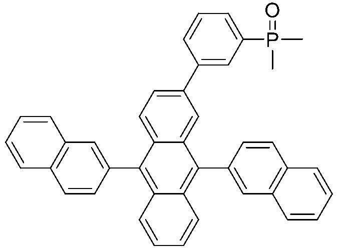 | 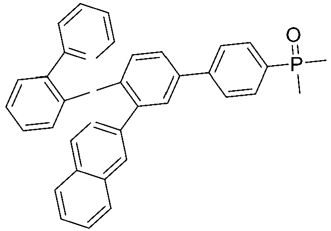 |
| 1-3 | 1-4 |
| 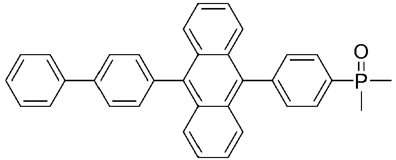 | 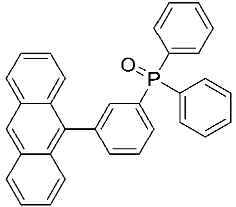 |
| 1-5 | 1-6 |
| 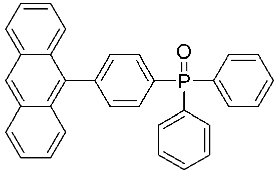 | 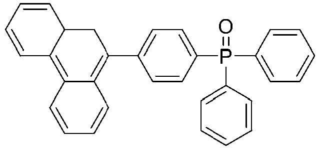 |
| 1-7 | 1-8 |
| 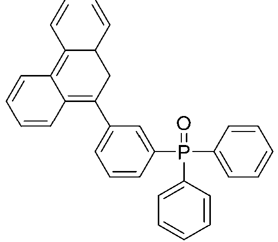 | 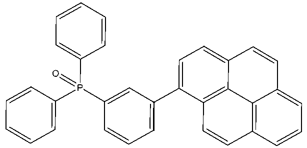 |
| 1-9 | 1-10 |
| 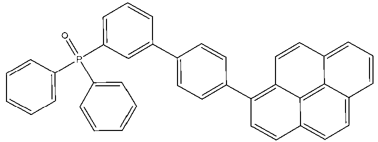 | 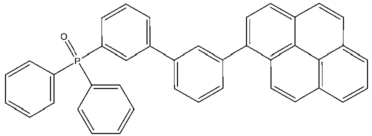 |
| 1-11 | 1-12 |
| 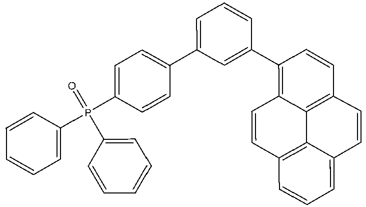 | 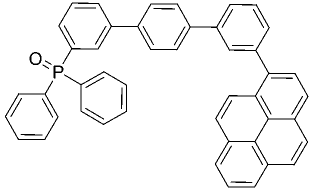 |
| 1-13 | 1-14 |
| 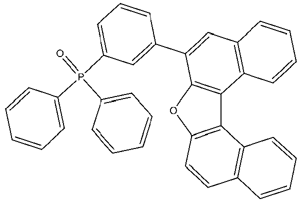 | 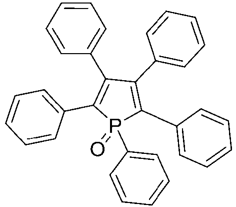 |
| 1-15 | 1-16 |
| 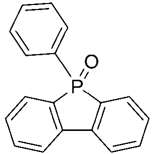 | 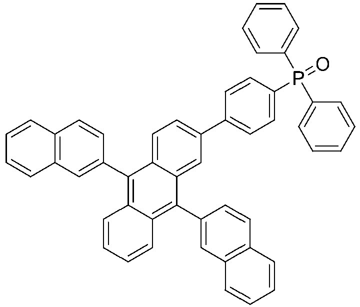 |
| 1-17 | 1-18 |
| 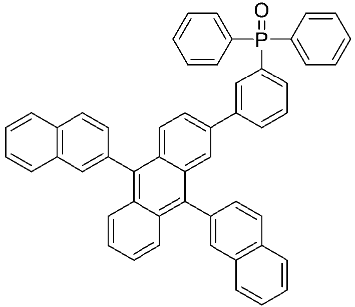 | 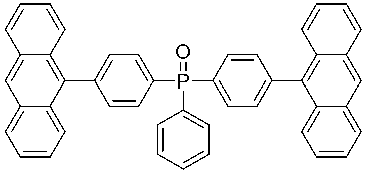 |
| 1-19 | 1-20 |
| 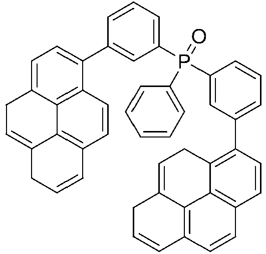 | 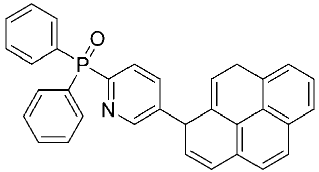 |
| 1-21 | 1-22 |
| 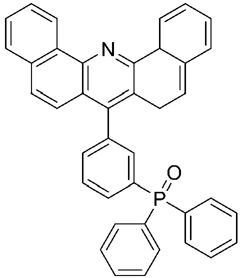 | 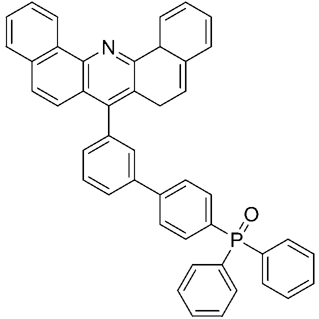 |
| 1-23 | 1-24 |
| 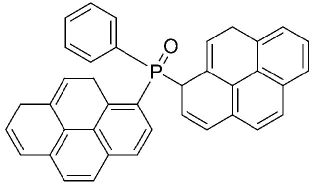 | 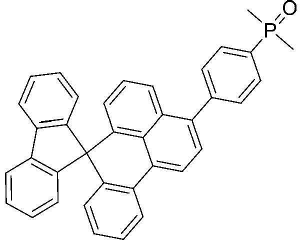 |
| 1-25 | 1-26 |
| 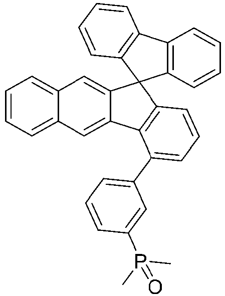 | 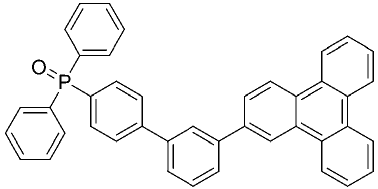 |
| 1-27 | 1-28 |
| 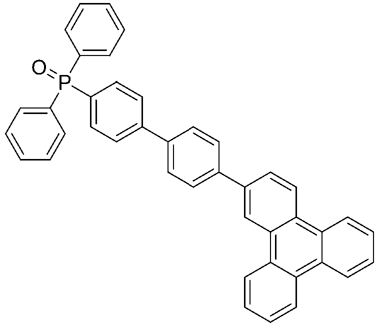 | 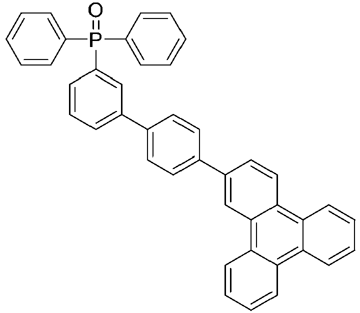 |
| 1-29 | 1-30 |
| 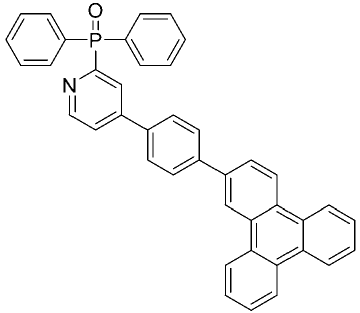 | 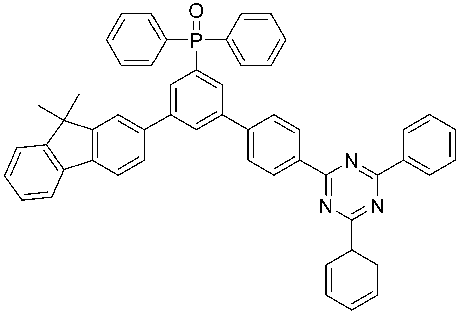 |
| 1-31 | 1-32 |
| 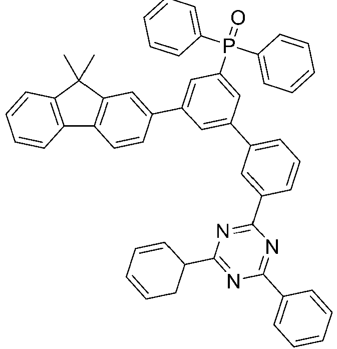 | 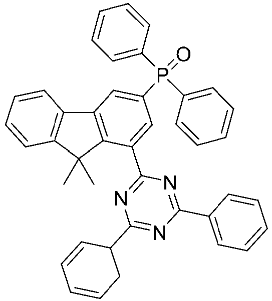 |
| 1-33 | 1-34 |
| 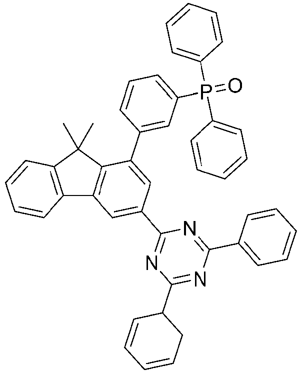 | 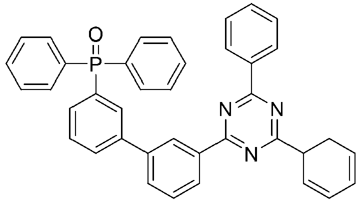 |
| 1-35 | 1-36 |
| 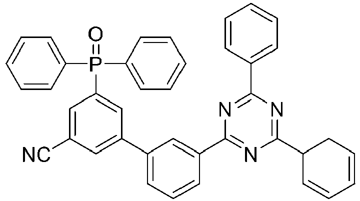 | 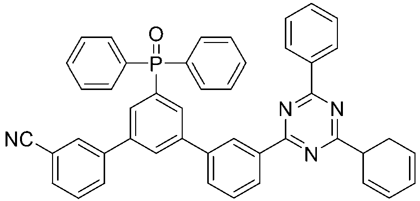 |
| 1-37 | 1-38 |
| 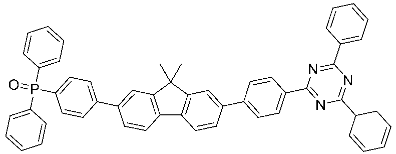 | 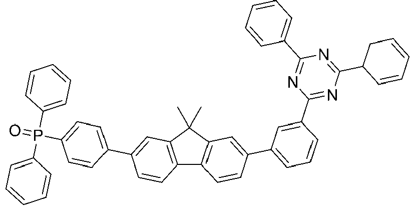 |
| 1-39 | 1-40 |
| 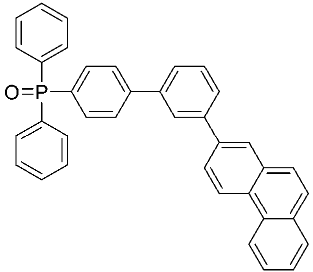 | 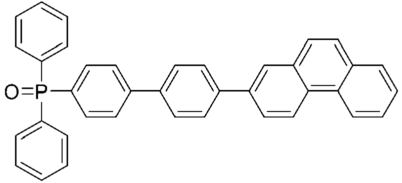 |
| 1-41 | 1-42 |

8. Organische lichtemittierende Vorrichtung nach einem der vorhergehenden Ansprüche, wobei die metallkomplexierende Gruppe ein dreiwertiges Stickstoffatom ist.

9. Organische lichtemittierende Vorrichtung nach einem der vorhergehenden Ansprüche, wobei die zweite organische Verbindung mindestens eine metallkomplexierende Gruppe umfasst, die eine C₂ - bis C₃₀ -Heteroarylgruppe umfasst, die mindestens ein Stickstoffatom umfasst.

10. Organische lichtemittierende Vorrichtung nach einem der vorhergehenden Ansprüche, wobei die zweite organische Verbindung mindestens eine metallkomplexierende Gruppe umfasst, die mindestens zwei Stickstoffatome umfasst.

11. Organische lichtemittierende Vorrichtung nach einem der vorhergehenden Ansprüche, wobei die zweite organische Verbindung eine oder mehrere der folgenden Verbindungen ist:
| | |
|---|---|
| 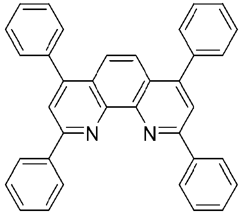 | 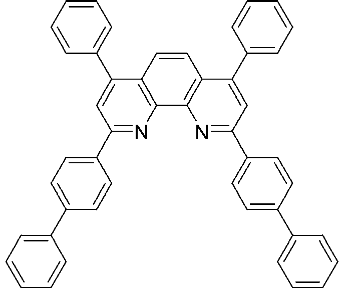 |
| 2-1 | 2-2 |
| 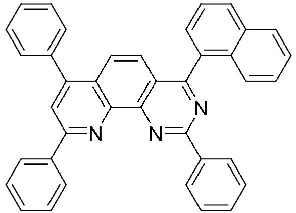 | 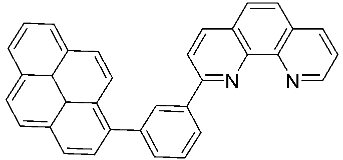 |
| 2-3 | 2-4 |
| 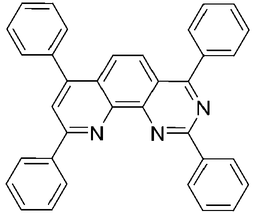 | 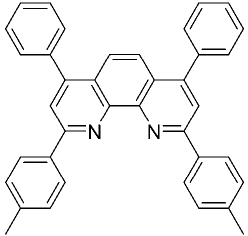 |
| 2-5 | 2-6 |
| 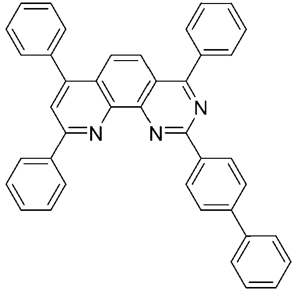 | 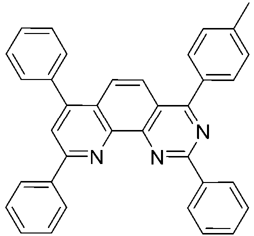 |
| 2-7 | 2-8 |
| 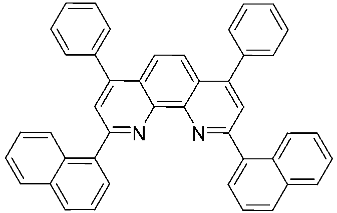 | 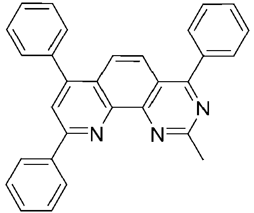 |
| 2-9 | 2-10 |
| 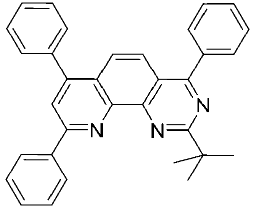 | 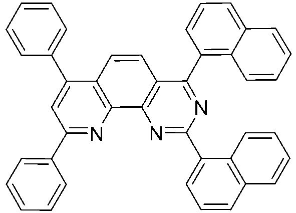 |
| 2-11 | 2-12 |
| 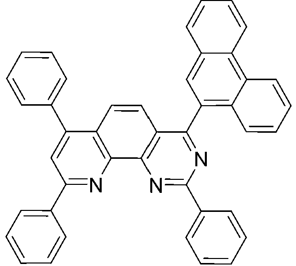 | 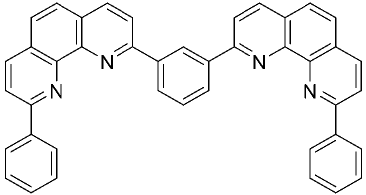 |
| 2-13 | 2-14 |
| 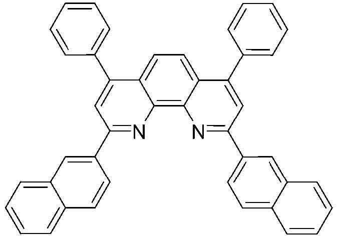 | 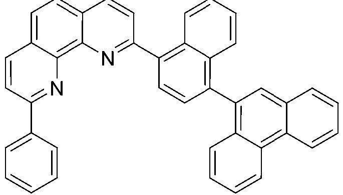 |
| 2-15 | 2-16 |
| 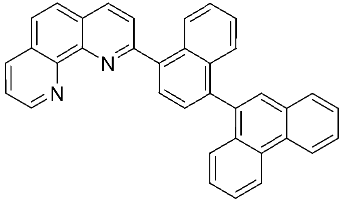 | 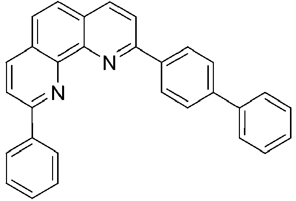 |
| 2-17 | 2-18 |
| 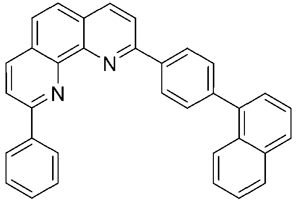 | 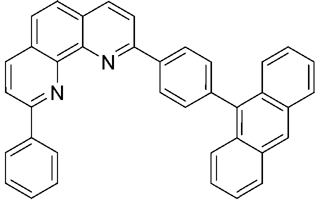 |
| 2-19 | 2-20 |
| 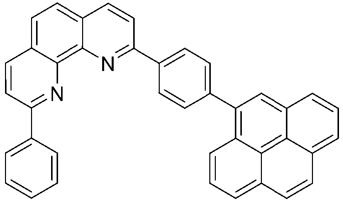 | 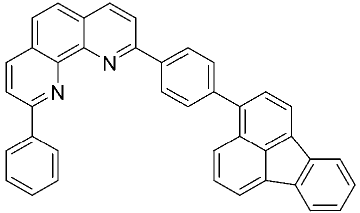 |
| 2-21 | 2-22 |
| 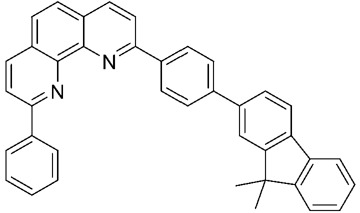 | 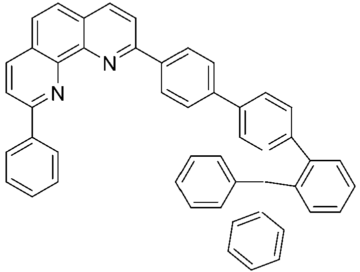 |
| 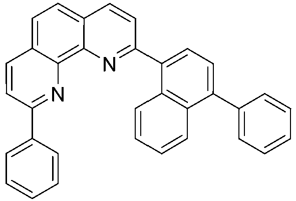 | 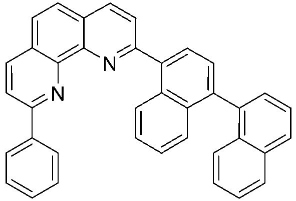 |
| 2-23 | 2-24 |
| 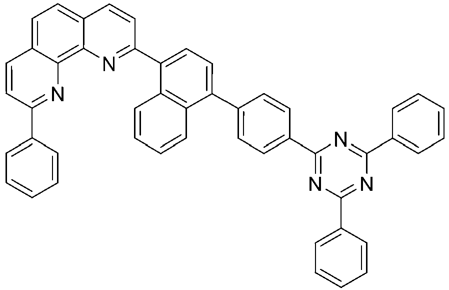 | 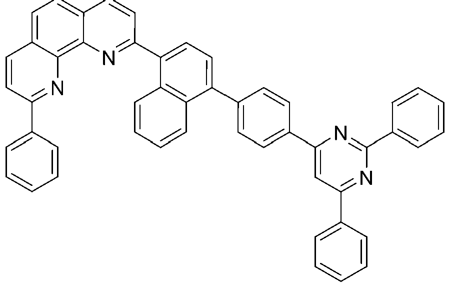 |
| 2-25 | 2-26 |
| 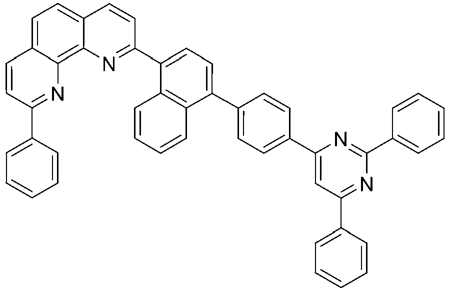 | 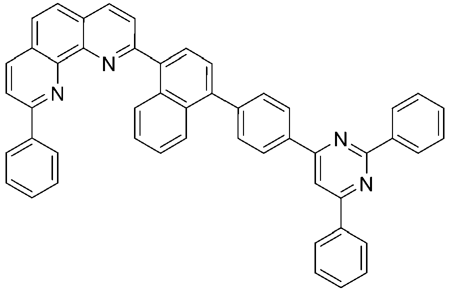 |
| 2-27 | 2-28 |
| 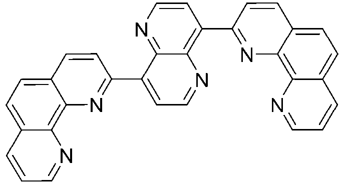 | 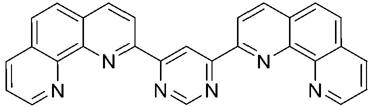 |
| 2-29 | 2-30 |
| 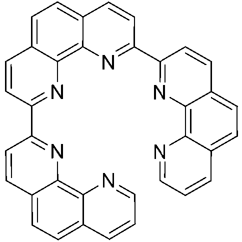 | 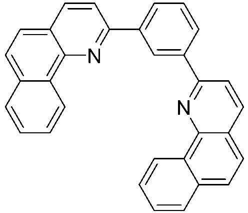 |
| 2-31 | 2-32 |
| 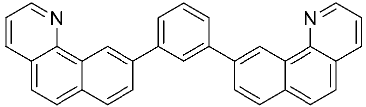 | 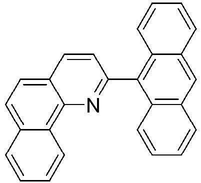 |
| 2-33 | 2-34 |
| 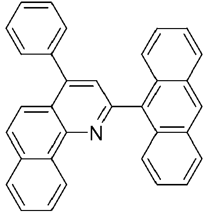 | 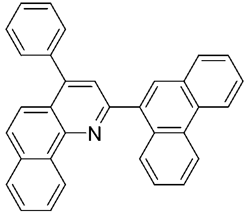 |
| 2-35 | 2-36 |

12. Verfahren zur Herstellung einer organischen lichtemittierenden Vorrichtung nach einem der vorhergehenden Ansprüche, wobei das Verfahren die folgenden Schritte umfasst
a1) Verdampfen der ersten organischen Verbindung und der zweiten organischen Verbindung aus separaten Verdampfungsquellen; oder
a2) gemeinsames Verdampfen der ersten organischen Verbindung und der zweiten organischen Verbindung aus derselben Verdampfungsquelle; und
b) gemeinsames Abscheiden der ersten und der zweiten organischen Verbindung.

## Revendications

1. Dispositif électroluminescent organique (1) comprenant une anode (3), une cathode (4), au moins deux couches d'émission (9, 14) et au moins une couche de génération de charge (5), dans lequel au moins deux couches d'émission (9, 14) sont disposées entre l'anode (3) et la cathode (4) et dans lequel au moins une couche de génération de charge (5) est disposée entre au moins deux couches d'émission ;
dans lequel la couche de génération de charge comprend une sous-couche de type n (5a) et une sous-couche de type p (5b),
dans lequel la sous-couche de type n (5a) comprend
a. au moins un premier composé organique, le premier composé organique comprenant un système conjugué d'au moins 10 électrons délocalisés et le premier composé organique comprenant au moins un groupe P=X, dans lequel X est choisi parmi O, S et Se ;
b. au moins un deuxième composé organique, le deuxième composé organique comprenant au moins un groupe complexant un métal, alternativement deux groupes complexant un métal ; dans lequel le premier composé organique est différent du deuxième composé organique ; et
c. un dopant métallique de valence zéro, dans lequel le dopant métallique de valence zéro est Li, Yb ou un mélange de ceux-ci.

2. Dispositif électroluminescent organique selon la revendication 1, dans lequel la couche de génération de charge comprend en outre une couche intermédiaire (16) disposée entre la sous-couche de type n et la sous-couche de type p.

3. Dispositif électroluminescent organique selon une quelconque des revendications précédentes, dans lequel le premier composé organique et le deuxième composé organique comprennent (comprend) un système conjugué d'au moins 10 électrons délocalisés.

4. Dispositif électroluminescent organique selon une quelconque des revendications précédentes, dans lequel le premier composé organique est représenté par la formule suivante (I) :
dans lequel X est choisi parmi O, S et Se ;
R¹, R² et R³ sont choisis indépendamment parmi les groupes composés de : alkyle en C₁ à C₃₀, cycloalkyle en C₃ à C₃₀, hétéroalkyle en C₂ à C₃₀, aryle en C₆ à C₆₀, hétéroaryle en C₂ à C₅₀, alcoxy en C₁ à C₃₀, cycloalkyloxy en C₃ à C₃₀, aryloxy en C₆ à C₃₀ ;
dans lequel au moins deux de R¹, R² et R³ peuvent être liés les uns aux autres pour former, avec l'atome P, un cycle à 5, 6 ou 7 chaînons,
dans lequel chacun de R¹, R² et R³ peut indépendamment comprendre un ou plusieurs groupes supplémentaires : aryle en C₆ à C₁₈, hétéroaryle en C₃ à C₂₀, -PO(R')₂, D, F ou CN, alkyle en C₁ à C₁₆, alcoxy en C₁ à C₁₆, nitrile, dans lequel R' représente un groupe phényle et/ou méthyle,
dans lequel si un ou plusieurs de R¹, R² et R³ est un groupe contenant du carbone comprenant au moins un atome de carbone directement lié à au moins un atome d'hydrogène, les atomes d'hydrogène compris dans le groupe contenant du carbone peuvent être partiellement ou totalement remplacés par des atomes de deutérium et/ou de fluor.

5. Dispositif électroluminescent organique selon une quelconque des revendications précédentes, dans lequel au moins un de R¹, R² et R³ est un phényle ou au moins un de R¹, R² et R³ est un alkyle en C₁ à C₄.

6. Dispositif électroluminescent organique selon la revendication 5, dans lequel R₃ est choisi parmi le groupe constitué de groupes aryle substitués ou non substitués en C₆ à C₆₀ et hétéroaryle en C₂ à C₅₀, dans lequel R³ peut indépendamment comprendre un ou plusieurs autres groupes aryle en C₆ à C₁₈, hétéroaryle en C₃ à C₂₀, -PO(R')₂, D, F ou CN, alkyle en C₁ à C₁₆, alcoxy en C₁ à C₁₆, nitrile, dans lequel R' représente un groupe phényle et/ou méthyle,
dans lequel si R³ est un groupe contenant du carbone comprenant au moins un atome de carbone directement lié à au moins un atome d'hydrogène, les atomes d'hydrogène compris dans le groupe contenant du carbone peuvent être partiellement ou totalement remplacés par des atomes de deutérium et/ou de fluor.

7. Dispositif électroluminescent organique selon une quelconque des revendications précédentes, dans lequel le premier composé organique est un ou plusieurs composés choisis parmi les suivants :
| | |
|---|---|
| 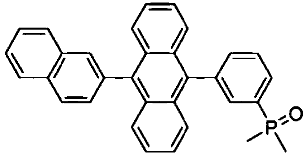 | 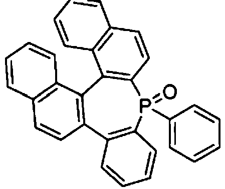 |
| 1-1 | 1-2 |
| 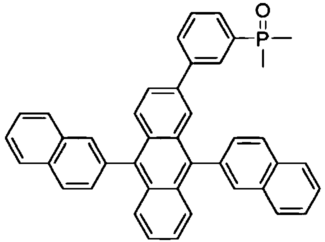 | 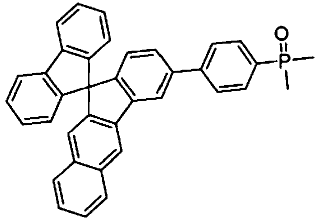 |
| 1-3 | 1-4 |
| 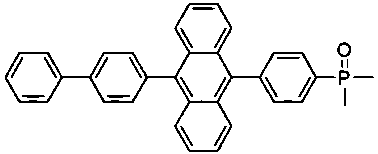 | 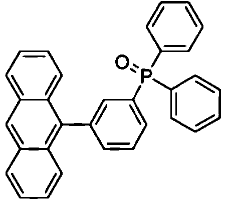 |
| 1-5 | 1-6 |
| 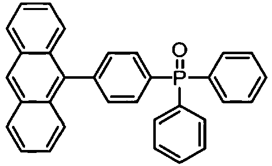 | 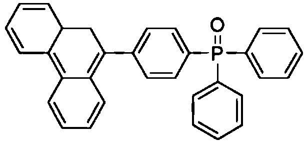 |
| 1-7 | 1-8 |
| 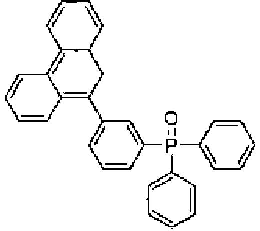 | 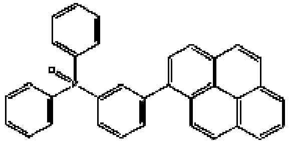 |
| 1-9 | 1-10 |
| 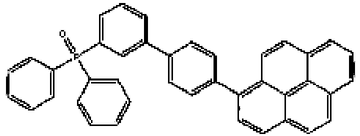 | 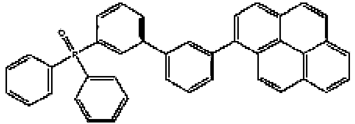 |
| 1-11 | 1-12 |
| 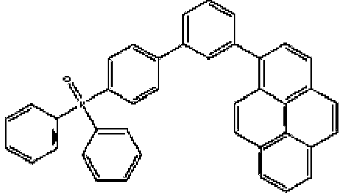 | 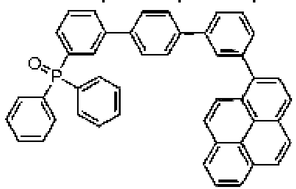 |
| 1-13 | 1-14 |
| 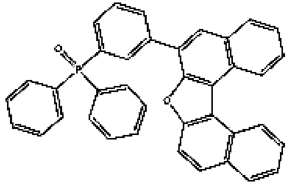 | 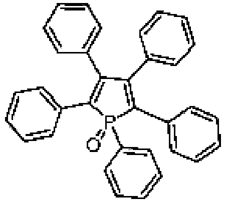 |
| 1-15 | 1-16 |
| 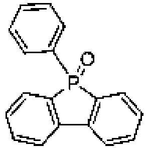 | 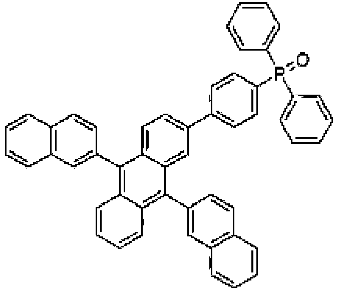 |
| 1-17 | 1-18 |
| 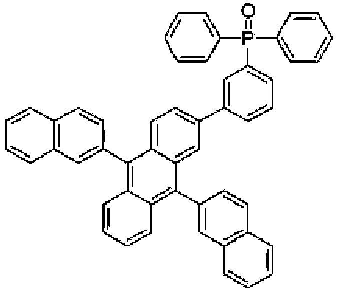 | 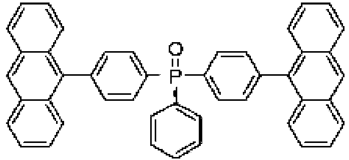 |
| 1-19 | 1-20 |
| 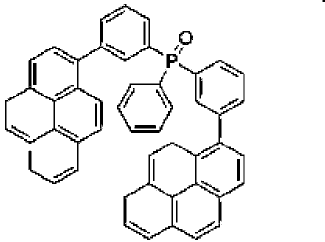 | 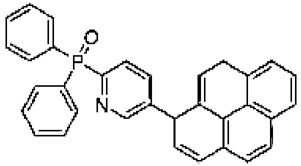 |
| 1-21 | 1-22 |
| 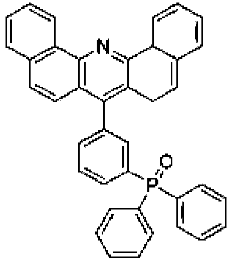 | 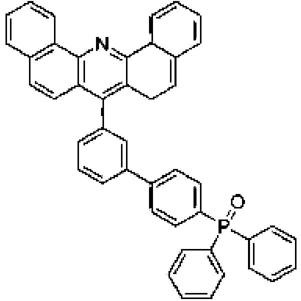 |
| 1-23 | 1-24 |
| 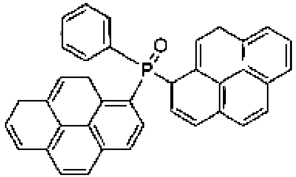 | 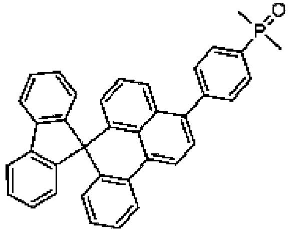 |
| 1-25 | 1-26 |
| 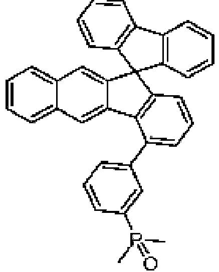 | 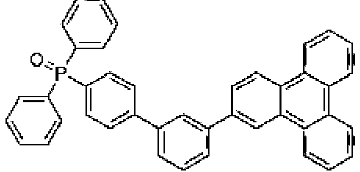 |
| 1-27 | 1-28 |
| 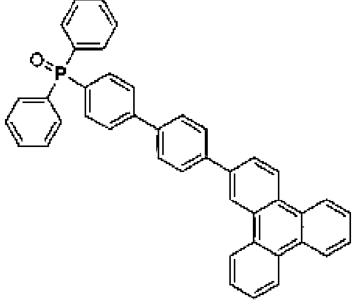 | 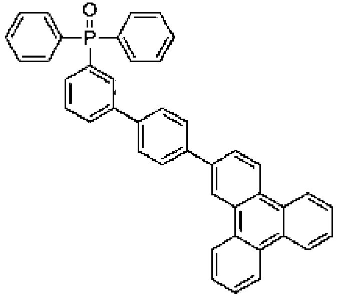 |
| 1-29 | 1-30 |
| 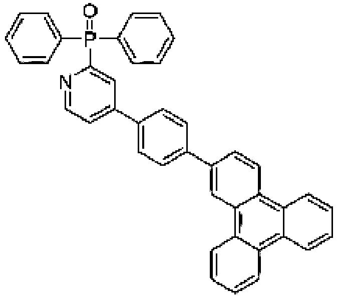 | 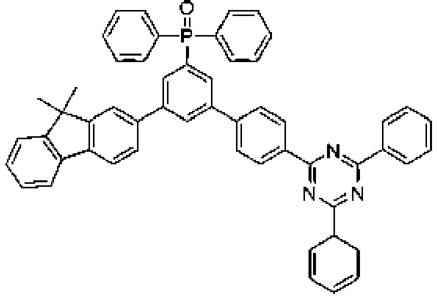 |
| 1-31 | 1-32 |
| 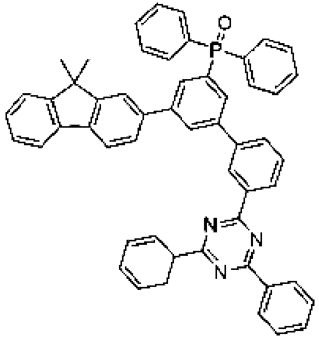 | 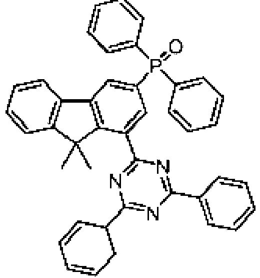 |
| 1-33 | 1-34 |
| 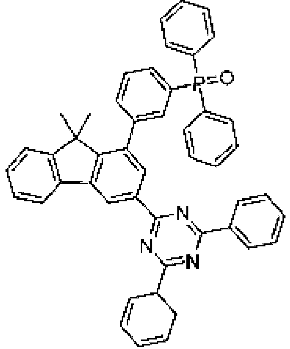 | 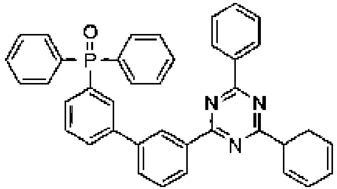 |
| 1-35 | 1-36 |
| 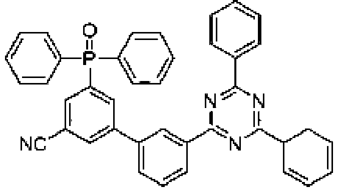 | 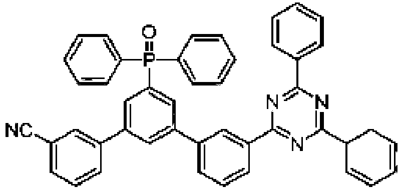 |
| 1-37 | 1-38 |
| 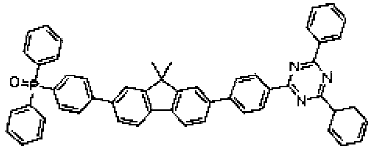 | 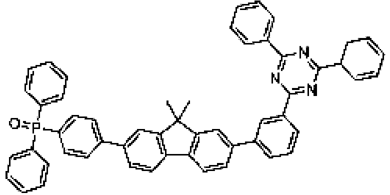 |
| 1-39 | 1-40 |
| 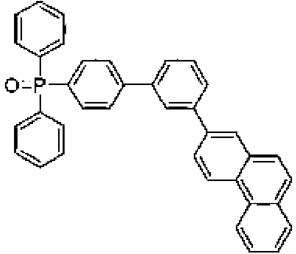 | 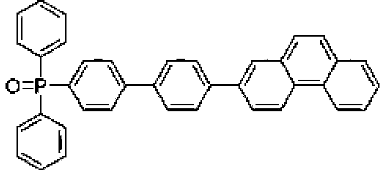 |
| 1-41 | 1-42 |

8. Dispositif électroluminescent organique selon une quelconque des revendications précédentes, dans lequel le groupe complexant le métal est un atome d'azote trivalent.

9. Dispositif électroluminescent organique selon une quelconque des revendications précédentes, dans lequel le deuxième composé organique comprend au moins un groupe complexant le métal comprenant un groupe hétéroaryle en C₂ à C₃₀ comportant au moins un atome d'azote.

10. Dispositif électroluminescent organique selon une quelconque des revendications précédentes, dans lequel le deuxième composé organique comprend au moins un groupe complexant le métal comportant au moins deux atomes d'azote.

11. Dispositif électroluminescent organique selon une quelconque des revendications précédentes, dans lequel le deuxième composé organique est un ou plusieurs des composés suivants.
| | |
|---|---|
| 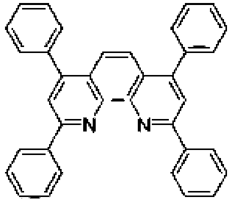 | 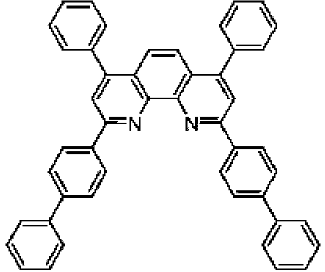 |
| 2-1 | 2-2 |
| 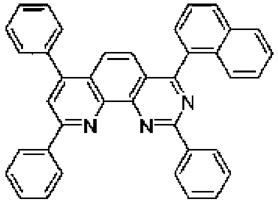 | 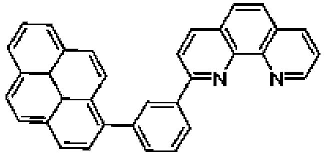 |
| 2-3 | 2-4 |
| 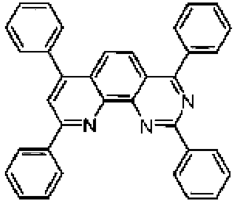 | 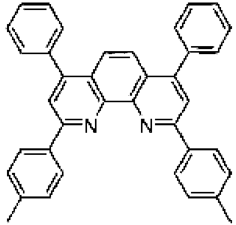 |
| 2-5 | 2-6 |
| 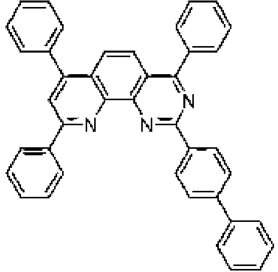 | 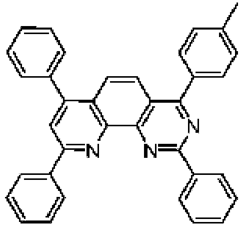 |
| 2-7 | 2-8 |
| 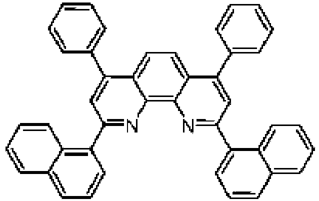 | 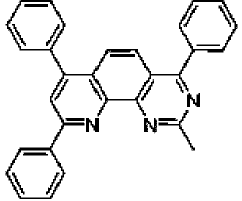 |
| 2-9 | 2-10 |
| 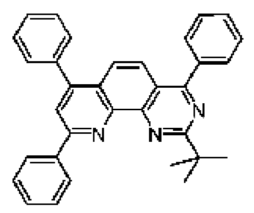 | 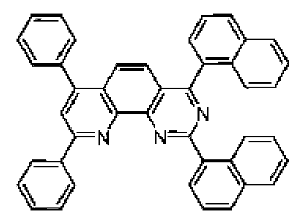 |
| 2-11 | 2-12 |
| 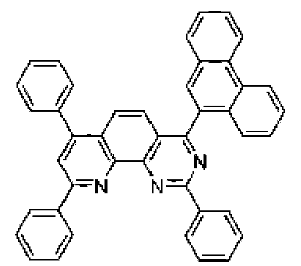 | 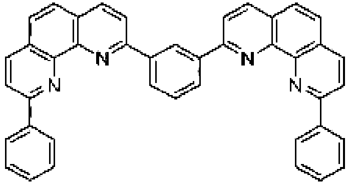 |
| 2-13 | 2-14 |
| 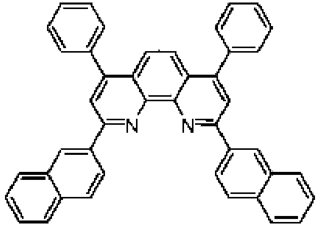 | 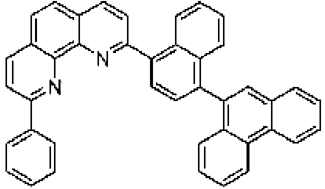 |
| 2-15 | 2-16 |
| 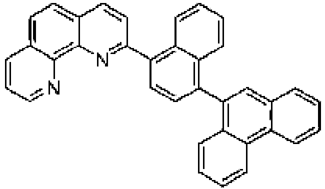 | 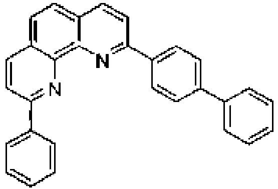 |
| 2-17 | 2-18 |
| 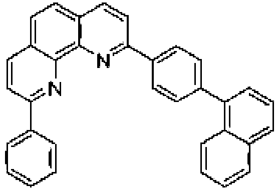 | 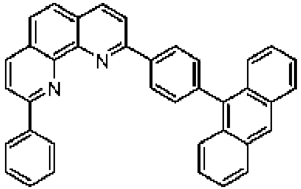 |
| 2-19 | 2-20 |
| 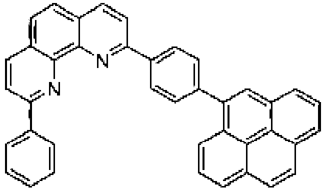 | 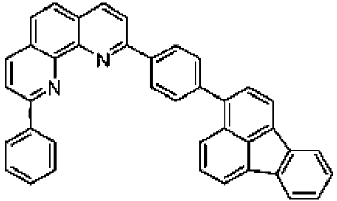 |
| 2-21 | 2-22 |
| 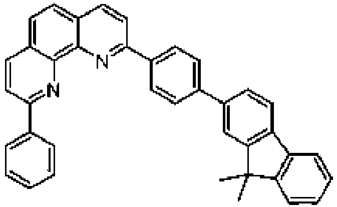 | 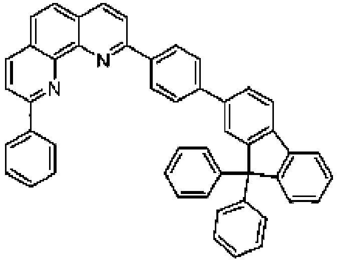 |
| 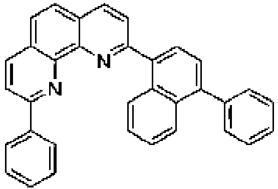 | 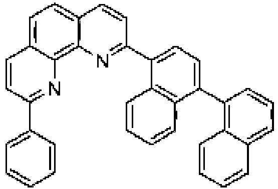 |
| 2-23 | 2-24 |
| 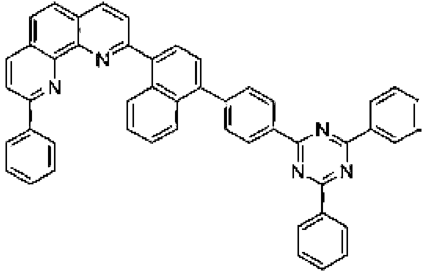 | 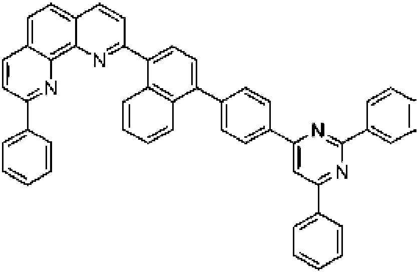 |
| 2-25 | 2-26 |
| 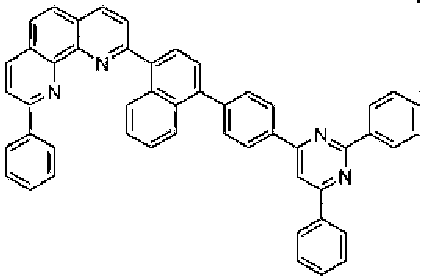 | 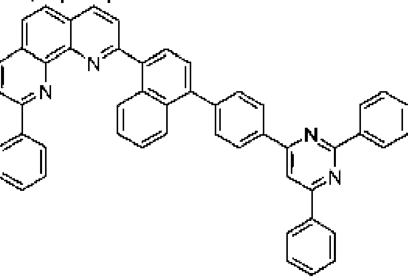 |
| 2-27 | 2-28 |
| 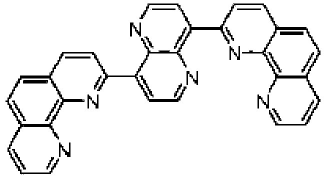 | 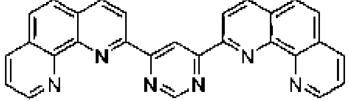 |
| 2-29 | 2-30 |
| 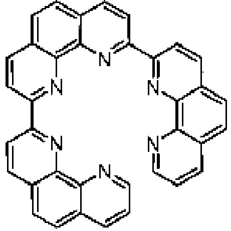 | 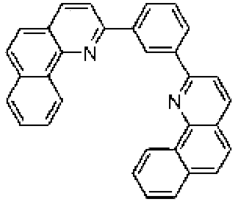 |
| 2-31 | 2-32 |
| 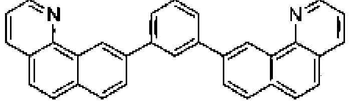 | 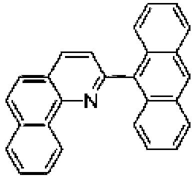 |
| 2-33 | 2-34 |
| 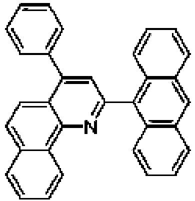 | 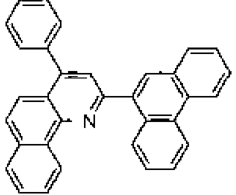 |
| 2-35 | 2-36 |

12. Procédé de fabrication d'un dispositif électroluminescent organique selon une quelconque des revendications précédentes, comprenant les étapes suivantes :
a1) évaporation du premier composé organique et du deuxième composé organique à partir de sources d'évaporation distinctes ; ou
a2) co-évaporation du premier composé organique et du deuxième composé organique à partir de la même source d'évaporation ; et
b) co-dépôt du premier et du deuxième composé organique.
